# EUROPEAN PATENT SPECIFICATION

(11) **EP 1 011 030 B1**
(45) Date of publication and mention of the grant of the patent: **17.04.2002**
(21) Application number: 99124870.9
(22) Date of filing: 16.12.1999
(51) Int. Cl.: G03F 7/004

(54) **Photosensitive lithographic printing plate**
Lichtempfindliche Flachdruckplatte
Plaque d'impression lithographique photosensible

(30) Priority: 16.12.1998 JP 35736298
(43) Date of publication of application: 21.06.2000
(73) Proprietor: FUJI PHOTO FILM CO., LTD., Kanagawa 250-01 (JP)
(72) Inventor: Fujita, Kazuo, Yoshida-cho, Haibara-gun, Shizuoka (JP); Kawamura, Koichi, Yoshida-cho, Haibara-gun, Shizuoka (JP); Watanabe, Noriaki, Yoshida-cho, Haibara-gun, Shizuoka (JP)
(74) Representative: HOFFMANN - EITLE

(56) References cited:
- EP-A- 0 843 218
- US-A- 4 803 145
- US-A- 5 300 628
- US-A- 5 422 221

## Description

### FIELD OF THE INVENTION

The present invention relates to a photosensitive lithographic printing plate comprising a coating of a photosensitive solution containing a fluorine based surface active copolymer, and more particularly to a photosensitive lithographic printing plate prepared by coating a support with a photosensitive solution containing a fluorine based copolymer from which injurious components generating coating defects such as cissing in film formation are effectively removed.

### BACKGROUND OF THE INVENTION

Fluorine based copolymers have significant surface tension reducing action, and are conveniently used as levelling agents, surface smoothing agents, water/oil repellents, soil retardants or lubricants in a wide range of industrial fields such as photographic films, presensitized plates, resist materials, paints and plastic films.

However, although the fluorine based copolymers are excellent in surface active effect, they generate coating defects in some cases, particularly when the coating film thickness is thin in film formation or depending on the kind and amount of paint resin composition or paint solvent. Such coating defects include, for example, pin holes, cissing, cratering and uneven coating, which sometimes become fatal defects to the quality of coated products. It is therefore an important technical problem to remove these coating defects.

In particular, when the fluorine based copolymers are used in presensitized plates, the problem arises that the ink receptivity (i.e., adhesion) thereof is insufficient, or that blank spots are developed in image areas of printed matter.

On the other hand, the fluorine based copolymers are scarcely purified by conventional techniques such as recrystallization and reprecipitation which are low in yields, because of their extremely difficult purification and high cost. Accordingly, as a measure to the coating defects such as cissing, the means is only employed that the amounts of fluorine based copolymers added into coating solutions are limited. Usually, as a measure to reduce cissing, it has been most effective to decrease the amounts added. However, needless to say, a decrease in the amounts added causes a lowering of a levelling function and other fluorine functions, resulting in deteriorated quality. This has therefore promoted discontent in use.

Further, a purification method by contact with fluorocarbon is described in JP-A-1-149812 (the term "JP-A" as used herein means an "unexamined published Japanese patent application"). However, even the use of this method does not provide the sufficient effect in some cases.

### SUMMARY OF THE INVENTION

The present invention has been made for solving the conventional problems as described above, and an object of the present invention is to provide a photosensitive lithographic printing plate improved in the coating defects such as cissing and uneven coating resulting from a fluorine based copolymer contained in a photosensitive layer, improved in the ink receptivity (i.e., adhesion), and having no blank spots in image areas after printing.

As a result of intensive investigation, the present inventors have discovered that the above-mentioned object is attained by (1) a photosensitive lithographic printing plate prepared by coating a support with a solution containing a fluorine based copolymer, a photosensitive compound, a binder and an organic solvent, followed by drying, the fluorine based copolymer being obtained by dissolving a copolymer having 1% to 80% by weight of a fluoro-substituted (meth)acrylate as a constituent unit in a solvent, and then, purifying the fluoro-substituted (meth) acrylate-containing copolymer by bringing the resulting solution into contact with an inorganic adsorbent containing 80% or more of an oxide of silicon, an oxide of aluminum or a mixture thereof; (2) a photosensitive lithographic printing plate prepared by coating a support with a solution containing a fluorine based copolymer, a photosensitive compound, a binder and an organic solvent, followed by drying, the fluorine based copolymer being obtained by dissolving a copolymer having 1% to 80% by weight of a fluoro-substituted (meth)acrylate as a constituent unit in a solvent, and then, purifying the fluoro-substituted (meth)acrylate-containing copolymer by bringing the resulting solution into contact with a synthetic adsorbent comprising a (modified) styrene-divinylbenzene copolymer or a (meth)acrylic ester based copolymer; or (3) a photosensitive lithographic printing plate prepared by coating a support with a solution containing a fluorine based copolymer, a photosensitive compound, a binder and an organic solvent, followed by drying, the fluorine based copolymer being obtained by dissolving a copolymer having 1% to 80% by weight of a fluoro-substituted (meth)acrylate as a constituent unit in a solvent, and then, purifying the fluoro-substituted (meth)acrylate-containing copolymer by filtering the resulting solution through a filter having a pore size of 1 µm or less.

That is to say, the present inventors have discovered that so-called cissing components can be selectively separated by dissolving a copolymer having 1% to 80% by weight of a fluoro-substituted (meth)acrylate as a constituent unit in a solvent, and then, purifying the fluoro-substituted (meth)acrylate-containing copolymer by (1) bringing the resulting solution into contact with an inorganic adsorbent containing 80 wt-% or more of an oxide of silicon, an oxide of aluminum or a mixture thereof, (2) bringing the resulting solution into contact with a synthetic adsorbent comprising a (modified) styrene-divinylbenzene copolymer or a (meth)acrylic ester based copolymer, or (3) filtering the resulting solution through a filter having a pore size of 1 µm or less. The present inventors have further discovered that coating of the support with a coating solution for a photosensitive layer containing the fluorine based copolymer thus purified allows to provide a homogeneous layer having no coating defects such as cissing and uneven coating, and to provide a lithographic printing plate having no blank spots in an image area after printing.

It is considered that components contributing to the generation of the coating defects, which are contained in the fluorine based copolymer-containing photosensitive solutions, are polymers (or oligomers) in which fluoroalkyl group-containing (meth)acrylate components are richly copolymerized in the fluorine based copolymers, or homopolymers (or oligomers) of fluoroalkyl group-containing (meth)acrylates. Although these components are contained in slight amounts, they are fluorine-rich components. Accordingly, they can not be homogeneously dispersed in coating films, resulting in liability to coagulation and association. It is considered that particularly, low surface energy portions in the coating films behave as nuclei generating cissing and the like in the drying course of the coating films.

Even if the solutions are uniformly coated without cissing, ink spreading (i.e., adhesion of ink) on fluorine-rich component portions becomes poor, resulting in the state of blank spots in printed matter, in the case of use in printing plate.

The present inventors have discovered that the fluorine-rich components forming the nuclei generating such cissing and blank spots are removed by filtering them through filters having a pore size of 1 µm or less, or allowing them to be adsorbed by adsorbents, thus completing the present invention.

### DETAILED DESCRIPTION OF THE INVENTION

The photosensitive lithographic printing plates of the present invention are prepared by coating supports with solutions containing fluorine based copolymers purified by the above-mentioned methods, photosensitive compounds, binders and organic solvent, followed by drying.

### [Fluorine Based Copolymers]

Although there is no particular limitation on the fluorine based copolymers used in the photosensitive lithographic printing plates of the present invention, polymers (or oligomers) having a molecular weight of 1,000 to 1,000,000 in which fluoroalkyl-substituted (meth)acrylates are copolymerized as one component monomers are suitable. The fluoroalkyl-substituted (meth)acrylates are preferably ones represented by formula Rf-Z-OCOCH=CH₃ or Rf-Z-OCOCH(CH₃)=CH₃, wherein Rf represents a fluoroalkyl group having 3 to 12 carbon atoms, and Z is a divalent connecting group and represents -SO₂N(A)CH₂CH₂-, -CON(A)CH₂CH₂- (wherein A represents hydrogen or an alkyl group having 1 to 6 carbon atoms), -CH₂- or -CH₂CH₂-, but are not limited thereto.

There is no particular limitation on monomers which copolymerize with the fluoroalkyl-substituted (meth)acrylates. Examples of derivatives of α,β-ethylenically unsaturated carboxylic acids include alkyl (meth)acrylates in which the alkyl has 1 to 18 carbon atoms, for example, methyl, ethyl, propyl, butyl, octyl, 2-ethylhexyl, dodecyl and stearyl esters of (meth)acrylic acid, and aminoalkyl (meth)acrylates in which the alkyl has 1 to 18 carbon atoms, for example, dimethylaminoethyl, diethylaminoethyl and diethylaminopropyl esters of (meth)acrylic acid. Further, examples of the derivatives include ether oxygen-containing alkyl acrylates in which the acrylic acid has 3 to 18 carbon atoms, for example, methoxyethyl, ethoxyethyl, methoxypropyl, methylcarbyl, ethylcarbyl and butylcarbyl esters of acrylic acid, and alkyl vinyl ethers in which the alkyl has 1 to 8 carbon atoms, for example, methyl vinyl ether, propyl vinyl ether and dodecyl vinyl ether. Still further, they include univalent or divalent carboxylic acids such as α,β-ethylenically unsaturated carboxylic acids, for example, acrylic acid, methacrylic acid, maleic acid, fumaric acid and itaconic acid, and hydroxyalkyl (meth)acrylate in which the alkyl has 1 to 18 carbon atoms, for example, 2-hydroxyethyl, 2-hydroxypropyl and 4-hydroxybutyl esters of (meth)acrylic acid, and monomers containing repeating units such as ethylene oxide and propylene oxide, that is to say, poly(alkylene oxides) on their side chains. Furthermore, they include macromonomers such as Styrene Macromonomer 4500 manufactured by Sirmart Co., and MMA Monomer manufactured by Toagosei Chemical Industry Co., Ltd.

Specific examples of the above-mentioned monomers include NK Ester M-20 G, M-40 G, M-90 G, M-230 G, M-540 G, AM-90G, 1G, 2G, 3G, 4G, 9G, 14G, 23G, 9PG, A-200, A-400, A-600, APG-400 and APG-700 (manufactured by Shinnakamura Kagaku Kogyo K.K.), and Blenmer PE-90, PE-200, PE-350, PME-100, PME-200, PME-400, PME-4000, PP-1000, PP-500, PP-800, 70EFP-350 B, 55PET-800, 50POEP-800 B, NKH-5050, PDE-50, PDE-100, PDE-150, PDE-200, PDE-400, PDE-600, AP-400, AE-350, ADE-200 and ADE-400 (manufactured by Nihon Yushi Co.).

Besides, examples of the above-mentioned monomers include styrene, nucleus-substituted styrene, acrylonitrile, vinyl chloride, vinylidene chloride, vinylpyridine, N-vinylpyrrolidone, vinylsulfonic acid, vinyl esters of fatty acids such as vinyl acetate, 2-(meth)acryloyloxyethylsuccinic acid, 2-acrylamido-2-methylpropanesulfonic acid, partially sulfonated styrene, mono(acryloyloxyethyl)acid phosphate, mono(methacryloyloxyethyl)acid phosphate, dibutyl fumarate, dimethyl fumarate and N-isopropylacrylamide.

Further, examples thereof include monomers represented by the following structures [1] to [4]:

CH₂=CA[CO-W-R₁-SO₂NH-R₂] [1]

CH₂=CA[CO-W-R₁-NHSO₂-R₄] [2]

CH₂=CA[CO-NR₃-(X)ₘ-Y-(OH)ₙ [3]

CH₂=CA[Z-(X)ₘ-Y-(OH)ₙ] [4]

wherein A represents a hydrogen atom, a halogen atom or an alkyl group; W represents oxygen or -NR₃-; R₃ represents a hydrogen atom, an alkyl group or an aryl group; R₁ represents an alkylene or arylene group which may have a substituent group; R₂ represents a hydrogen atom, an alkyl group or an aryl group; R₄ represents an alkyl group or an aryl group; Y and Z represent arylene groups which may be the same or different; X is a connecting group and has a divalent organic group comprising an atom selected from the group consisting of carbon, oxygen, sulfur, halogen and hydrogen atoms; m represents an integer of 0 or 1; and n represents an integer of 1 to 3.

Preferred examples thereof are shown below:

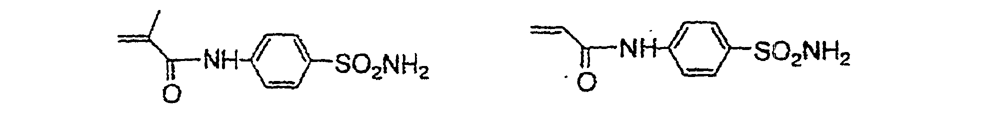

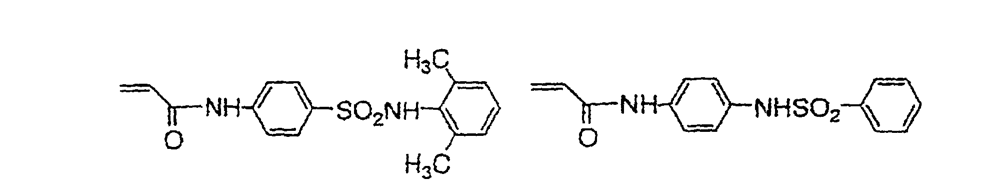

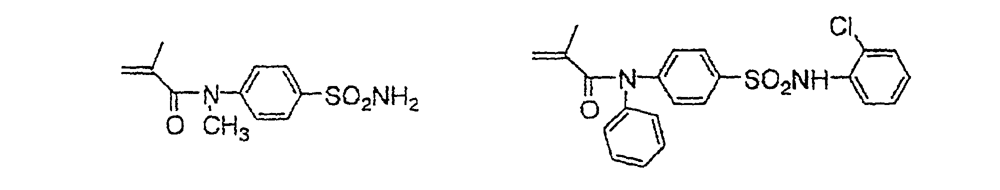

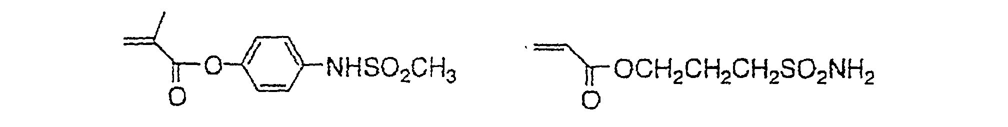

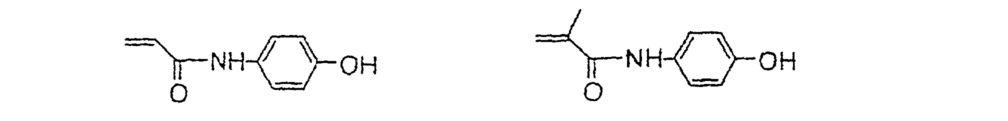

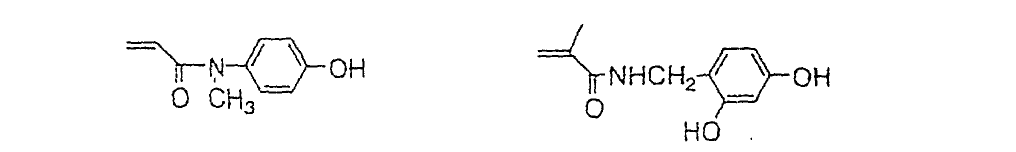

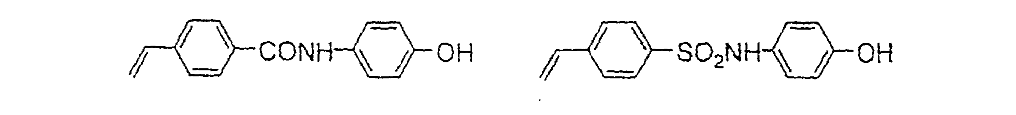

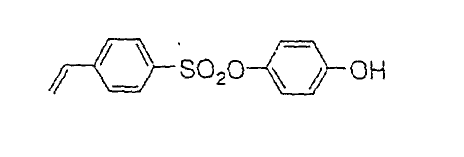

Further, the above-mentioned monomers may be combined.

The reaction ratio of the fluoroalkyl-substituted (meth)acrylates of the present invention to the above-mentioned monomers other than the fluoroalkyl-substituted (meth)acrylates is usually from 1:99 to 70:30, and preferably from 10:90 to 50:50, by weight ratio.

Examples of such fluorine based copolymers include but are not limited to copolymers described in JP-A-62-36657, JP-A-62-226143, JP-A-3-172849, JP-A-8-15858, JP-A-10-142778, JP-A-10-161303, JP-A-10-186642, JP-A-10-207052 and Japanese Patent Application No. 10-118961.

### [Methods for Purifying Fluorine Based Copolymers]

The present invention is characterized by that the above-mentioned fluorine based copolymers are purified by the following methods. The copolymers having 1% to 80% by weight of the fluoro-substituted (meth)acrylates as constituent units are dissolved in solvents, and then, they are (1) brought into contact with inorganic adsorbents containing 80% or more of oxides of silicon, oxides of aluminum or mixtures thereof, (2) brought into contact with synthetic adsorbents comprising (modified) styrene-divinylbenzene copolymers or (meth)acrylic ester based copolymers, or (3) filtered through filters having a pore size of 1 µm or less, thereby purifying them.

Examples of the solvents in which the above-mentioned fluorine compounds are dissolved when they are purified in the present invention include, for example, alcohols such as methyl alcohol, ethyl alcohol, n- or iso-propyl alcohol, n- or iso-butyl alcohol and diacetone alcohol; ketones such as acetone, methyl ethyl ketone, methyl propyl ketone, methyl butyl ketone, methyl amyl ketone, methyl hexyl ketone, diethyl ketone, diisobutyl ketone, cyclohexanone, methylcyclohexanone and acetylacetone; hydrocarbons such as benzene, toluene, xylene, cyclohexane and methoxybenzene; acetates such as ethyl acetate, n- or iso-propyl acetate, n- or iso-butyl acetate, ethylbutyl acetate and hexyl acetate; halides such as methylene dichloride, ethylene dichloride and monochlorobenzene; ethers such as isopropyl ether, n-butyl ether, dioxane, dimethyldioxane and tetrahydrofuran; polyhydric alcohols and derivatives thereof such as ethylene glycol, methyl cellosolve, cellosolve acetate, butyl cellosolve, butyl cellosolve acetate, methoxymethoxyethanol, diethylene glycol monomethyl ether, diethylene glycol dimethyl ether, diethylene glycol dimethyl ethyl ether, diethylene glycol diethyl ether, propylene glycol, propylene glycol monomethyl ether, propylene glycol monomethyl ether acetate, propylene glycol monoethyl ether, propylene glycol monoethyl ether acetate, propylene glycol monobutyl ether, 1-methoxy-2-propanol and 3-methyl-3-methoxybutanol; and special solvents such as dimethyl sulfoxide, N,N-dimethylformamide and N,N-dimethylacetylamide. These are properly used either alone or as a mixture thereof. Further, the solution concentration is suitably from 1% to 60% by weight, and preferably from about 2% to about 40% by weight without particular limitation.

### (1) Purification with Inorganic Adsorbents

The inorganic adsorbents containing 80% or more of oxides of silicon, oxides of aluminum or mixtures thereof used in the present invention may be hydrates, and may further contain oxides of Fe, P, Ti, Ca, Mg, Na, K and the like. Well-known adsorbents can be used. Examples thereof include activated alumina, diatomaceous earth, activated clay; silica gel and zeolite. They can be used either alone or as a mixture of two or more of them.

Although there is no particular limitation on the amount of these adsorbents used for the copolymers to be purified, the adsorbent/copolymer to be purified is preferably from 1/1000 to 1000/1, and particularly preferably from 1/100 to 100/1, on the basis of weight.

For bringing the adsorbents into contact with the fluorine based copolymers, any methods for enhancing dispersibility are used. Usually, methods such as stirring, vibration and ultrasonic vibration are used. It is preferred that the contact time is usually from about 10 minutes to about 10 hours. Although there is no particular -limitation on the temperature in contacting, it is preferably from 0°C to 100°C. After the fluorine based copolymers are brought into contact with the adsorbents, the adsorbents are separated. As separation methods, for example, the adsorbents are separated by filtration using filter members. Examples of materials of such filter members include without particular limitation cellulose, PTFE, polypropylene, SUS, polybutylene terephthalate and glass. As operation processes, any of natural filtration, pressure filtration, vacuum filtration and centrifugal filtration may be used.

### (2) Purification with Synthetic Adsorbents

The synthetic adsorbents of the (modified) styrene-divinylbenzene copolymers or the (meth)acrylate based copolymers include but are not limited to Amberlite XAD-2, Amberlite XAD-4, Amberlite XAD-7, Amberlite XAD-8, Amberlite XAD-9, Amberlite XAD-10, Amberlite XAD-11 and Amberlite XE-284 (manufactured by Rohm & Haas Co.), and Diaion HP10, Diaion HP20, Diaion HP21, Diaion HP30, Diaion HP40, Diaion HP50, Diaion HP1MG, Diaion HP2MG, Sepabeads SP800, Sepabeads SP900, Sepabeads SP206 and Sepabeads SP207 manufactured by Mitsubishi Chemical Corporation.

Although there is no particular limitation on the amount of these adsorbents used to the copolymers to be purified, the adsorbent/copolymer to be purified is preferably from 1/1000 to 1000/1, and particularly preferably from 1/100 to 100/1, on the basis of weight.

For bringing the adsorbents into contact with the fluorine based copolymers, any methods for enhancing dispersibility are used. Usually, methods such as stirring, vibration and ultrasonic vibration are used. It is preferred that the contact time is usually from about 10 minutes to about 10 hours. Although there is no particular limitation on the temperature in contacting, it is preferably from 0°C to 100°C.

After the fluorine based copolymers are thus brought into contact with the adsorbents, the adsorbents are separated. Separation can be carried out in the same manner as with the inorganic adsorbents.

### (3) Purification by Filtration Using Filters Having a Pore Size of 1 µm or Less

The copolymers having 1% to 80% by weight of the fluoro-substituted (meth)acrylates as constituent units are dissolved in solvents, and then, filtered through filters having a pore size of 1 µm or less, thereby purifying them.

The filters used in the present invention may be any, as long as they have a pore size of 1 µm or less. Materials thereof include, for example, cellulose, PTFE, polypropylene, SUS and polybutylene terephthalate. Examples of forms thereof include, for example, membrane filters, membrane cartridge filters, pleated cartridge filters and depth cartridge filters. As operation processes, any of natural filtration, pressure filtration, vacuum filtration and centrifugal filtration may be used. For precipitating cissing substances to increase the purification efficiency, still standing at low temperature is preferred. As an example, the still standing conditions of -15°C to 30°C and 5 hours to 100 hours are preferred.

Further, after the fluorine based copolymers dissolved in the solvents are brought into contact with the respective adsorbents as described in the above (1) or (2), they may be filtered using the filters having a pore size of 1 µm or less described in the above (3), thereby purifying them.

### [Photosensitive Compounds]

The photosensitive compounds used in the photosensitive lithographic printing plates of the present invention are described in detail below.

As the photosensitive compounds used in the present invention, either of positive working and negative working compounds can be used, as long as their solubility or swelling property against developing solutions varies after exposure to make them soluble.

### [Positive Working Photosensitive Compounds and Binders]

As the photosensitive compounds used in the photosensitive lithographic printing plates of the present invention, for example, positive working photosensitive compounds are exemplified. Examples of the positive working photosensitive compounds include o-quinonediazide compounds such as compounds obtained by polymerizing o-naphthoquinonediazide compounds. As the o-naphthoquinonediazide compounds, esters of 1,2-diazonaphthoquinonesulfonyl chloride and pyrogallol-acetone resins described in JP-B-43-28403 (the term "JP-B" as used herein means an "examined Japanese patent publication") are preferred.

Other preferred examples of the o-quinonediazide compounds include esters of 1,2-diazonaphthoquinonesulfonyl chloride and phenol-formaldehyde resins described in U.S. Patents 3,046,120 and 3,188,210.

Other examples of the useful o-naphthoquinonediazide compounds include compounds reported in a number of patents and known. Examples thereof include compounds described in JP-A-47-5303, JP-A-48-63802, JP-A-48-63803, JP-A-48-96575, JP-A-49-38701, JP-A-48-13354, JP-B-37-18015, JP-B-41-11222, JP-B-45-9610, JP-B-49-17481, JP-A-5-11444, JP-A-5-19477, JP-A-5-19478, JP-A-5-107755, U.S. Patents 2,797,213, 3,454,400, 3,544,323, 3,573,917, 3,674,495 and 3,785,825, British Patents 1,227,602, 1,251,345, 1,267,005, 1,329,888 and 1,330,932, and German Patent 854,890.

Further, as the other o-quinonediazide compounds, o-naphthoquinonediazide compounds obtained by the reaction of polyhydroxy compounds having a molecular weight of 1,000 or less with 1,2-diazonaphthoquinonesulfonyl chloride can also be used. Examples thereof include compounds described in JP-A-51-139402, JP-A-58-150948, JP-A-58-203434, JP-A-59-165053, JP-A-60-121445, JP-A-60-134235, JP-A-60-163043, JP-A-61-118744, JP-A-62-10645, JP-A-62-10646, JP-A-62-153950, JP-A-62-178562, JP-A-64-76047, U.S. Patents 3,102,809, 3,126,281, 3,130,047, 3,148,983, 3,184,310, 3,188,210 and 4,639,406.

When these o-naphthoquinonediazide compounds are synthesized, preferably, 0.2 to 1.2 equivalents, more preferably, 0.3 to 1.0 equivalent of 1,2-diazonaphthoquinone-sulfonyl chloride is preferably reacted, based on hydroxyl groups of the polyhydroxy compounds. As 1,2-diazonaphthoquinonesulfonyl chloride, 1,2-diazonaphthoquinone-5-sulfonyl chloride is preferred, but 1,2-diazonaphthoquinone-4-sulfonyl chloride can also be used. The resulting o-naphthoquinonediazide compounds are mixtures of compounds variously different in the position and the amount of 1,2-diazonaphthoquinone-sulfonate introduced. The ratio of compounds in which all hydroxyl groups are converted to 1,2-diazonaphthoquinone-sulfonate to the mixtures (the content of completely esterified compounds) is preferably 5 mol% or more, and more preferably from 20 mol% to 99 mol%.

Further, as photosensitive compounds functioning as the positive working compounds without using the o-naphthoquinonediazide compounds, for example, o-nitrile carbinol ester group-containing polymer compounds described in JP-B-52-2696, pyridinium group-containing compounds (JP-A-4-365049) and diazonium group-containing compounds (JP-A-5-249664, JP-A-6-83047, JP-A-6-324495 and JP-A-7-72621) can also be used in the present invention. Still further, a combined system of compounds generating acids by photolysis (JP-A-4-121748 and JP-A-4-365043) and C-O-C group- or C-O-Si group-containing compounds dissociating with acids can also be used in the present invention. Examples thereof include a combination of compounds generating acids by photolysis with acetal or O,N-acetal compounds (JP-A-48-89003), a combination of the compounds with orthoesters or amidoacetal compounds (JP-A-51-120714), a combination of the compounds with polymers having acetal or ketal groups on their main chains (JP-A-53-133429), a combination of the compounds with enol ether compounds (JP-A-55-12995, JP-A-4-19748 and JP-A-6-230574), a combination of the compounds with N-acyliminocarbon compounds (JP-A-55-126236), a combination of the compounds with polymers having orthoester groups on their main chains (JP-A-56-17345), a combination of the compounds with polymers having silyl ester groups (JP-A-60-10247) and a combination of the compounds with polymers having silyl ether compounds (JP-A-60-37549, JP-A-60-121446, JP-A-63-236028, JP-A-63-236029 and JP-A-63-276046).

Furthermore, as the photosensitive compounds functioning as the positive working compounds without using the o-naphthoquinonediazide compounds, aromatic sulfone compounds and onium-containing compounds can also be used in the present invention. In these cases, the compounds effectively function as the positive working compounds by a combination with compounds absorbing infrared light to near infrared light to generate heat. As the compounds absorbing infrared light to near infrared light to generate heat, compounds such as carbon black, cyanine dyes, methine dyes and naphthoquinone dyes are known.

The amount of these photosensitive compounds (including the combinations as described above) functioning as the positive working compounds contained in the solids of the photosensitive layers is suitably from 1% to 50% by weight, and more preferably from 10% to 40% by weight.

When the above-mentioned photosensitive compounds functioning as the positive working compounds are used in the photosensitive lithographic printing plates of the present invention, it is desirable to use them in combination with resins soluble in alkaline water as binders. As such resins soluble in alkaline water, there are novolak resins having this property. Examples thereof include phenol-formaldehyde resins and cresol-formaldehyde resins such as m-cresol-formaldehyde resins, p-cresolformaldehyde resins, m-/p-mixed cresol-formaldehyde resins and phenol/cresol-mixed formaldehyde resins (wherein cresol may be any of m-, p-, o- and m-/p-/o-mixed). These alkali-soluble polymers preferably have a weight average molecular weight of 500 to 100,000.

In addition, resol type phenol resins are also properly used, and phenol/cresol-mixed formaldehyde resins (wherein cresol may be any of m-, p-, o- and m-/p-/o-mixed). In particular, phenol resins described in JP-A-61-217034 are preferred.

Further, the photosensitive compounds can contain various alkali-soluble polymers such as phenol-modified xylene resins, polyhydroxystyrene, polyhydroxystyrene halides, acrylic resins containing phenolic hydroxyl groups as disclosed in JP-A-51-34711, vinyl resins or urethane resins having sulfonamido groups described in JP-A-2-866, and vinyl resins having structure units described in JP-A-7-28244, JP-A-7-36184, JP-A-7-36185, JP-A-7-248628, JP-A-7-261394 and JP-A-7-333839. In particular, in vinyl resins, film-forming resins are preferred each of which has as a polymerization component at least one selected from the group consisting of alkali-soluble group-containing monomers of (1) to (4) shown below:
(1) Aromatic hydroxyl group-containing acrylamides, methacrylamides, acrylates, methacrylates and hydroxystyrenes such as N-(4-hydroxyphenyl)acrylamide or N-(4-hydroxyphenyl)-methacrylamide, o-, m- or p-hydroxystyrene, o- or m-bromo-p-hydroxystyrene, o- or m-chloro-p-hydroxystyrene and o-, m- or p-hydroxyphenyl acrylate or methacrylate;
(2) Unsaturated carboxylic acids such as acrylic acid, methacrylic acid, maleic acid, maleic anhydride and a half ester thereof, itaconic acid itaconic anhydride and a half ester thereof;
(3) Acrylamides such as N-(o-aminosulfonylphenyl)-acrylamide, N-(m-aminosulfonylphenyl)acrylamide, N-(p-amino-sulfonylphenyl)acrylamide, N-[1-(3-aminosulfonyl)-naphthyl]acrylamide and N-(2-aminosulfonylethyl)acrylamide, methacrylamides such as N-(o-aminosulfonylphenyl)methacrylamide, N-(m-aminosulfonylphenyl)methacrylamide, N-(p-aminosulfonylphenyl)methacrylamide, N-[1-(3-aminosulfonyl)-naphthyl]methacrylamide and N-(2-aminosulfonylethyl)-methacrylamide, unsaturated sulfonamides of acrylates such as o-aminosulfonylphenyl acrylate, m-aminosulfonylphenyl acrylate, p-aminosulfonylphenyl acrylate and 1-(3-aminosulfonylphenylnaphthyl) acrylate, and unsaturated sulfonamides of methacrylates such as o-aminosulfonylphenyl methacrylate, m-aminosulfonylphenyl methacrylate, p-aminosulfonylphenyl methacrylate and 1-(3-aminosulfonylphenylnaphthyl) methacrylate; and
(4) Phenylsulfonylacrylamides, which may have substituent groups, such as tosylacrylamide, and phenylsulfonylmethacrylamides, which may have substituent groups, such as tosylmethacrylamide.
   Further, film forming resins are preferably used in which monomers of (5) to (14) described below are copolymerized, besides these alkali-soluble group-containing monomers.
(5) Acrylates or methacrylates having aliphatic hydroxyl groups, for example, 2-hydroxyethyl acrylate or 2-hydroxyethyl methacrylate;
(6) (Substituted) acrylates such as methyl acrylate, ethyl acrylate, propyl acrylate, butyl acrylate, amyl acrylate, hexyl acrylate, cyclohexyl acrylate, octyl acrylate, phenyl acrylate, benzyl acrylate, 2-chloroethyl acrylate, 4-hydroxybutyl acrylate, glycidyl acrylate and N-dimethylaminoethyl acrylate;
(7) (Substituted) methacrylates such as methyl methacrylate, ethyl methacrylate, propyl methacrylate, butyl methacrylate, amyl methacrylate, hexyl methacrylate, cyclohexyl methacrylate, octyl methacrylate, phenyl methacrylate, benzyl methacrylate, 2-chloroethyl methacrylate, 4-hydroxybutyl methacrylate, glycidyl methacrylate and N-dimethylaminoethyl methacrylate;
(8) Acrylamides or methacrylamides such as acrylamide, methacrylamide, N-methylolacrylamide, N-methylolmethacrylamide, N-ethylacrylamide, N-ethylmethacrylamide, N-hexylacrylamide, N-hexylmethacrylamide, N-cyclohexylacrylamide, N-cyclohexylmethacrylamide, N-hydroxyethylacrylamide, N-hydroxyethylmethacrylamide, N-phenylacrylamide, N-phenylmethacrylamide, N-benzylacrylamide, N-benzylmethacrylamide, N-nitrophenylacrylamide, N-nitrophenylmethacrylamide, N-ethyl-N-phenylacrylamide and N-ethyl-N-phenylmethacrylamide;
(9) Vinyl ethers such as ethyl vinyl ether, 2-chloroethyl vinyl ether, hydroxyethyl vinyl ether, propyl vinyl ethers, butyl vinyl ether, octyl vinyl ether and phenyl vinyl ether;
(10) Vinyl esters such as vinyl acetate, vinyl chloroacetate, vinyl butylate and vinyl benzoate;
(11) Styrenes such as styrene, α-methylstyrene, methylstyrene and chloromethylstyrene;
(12) Vinyl ketones such as methyl vinyl ketone, ethyl vinyl ketone, propyl vinyl ketone and phenyl vinyl ketone;
(13) Olefins such as ethylene, propylene, isobutylene, butadiene and isoprene; and
(14) N-vinylpyrrolidone, N-vinylcarbazole, 4-vinylpyridine, acrylonitrile and methacrylonitrile.

These alkali-soluble polymers preferably have a weight average molecular weight of 500 to 500,000 (particularly preferably 1,000 to 200,000).

Such alkali-soluble polymers may be used either alone or as a combination of two or more of them, and are added in an amount of 99% by weight or less, preferably 98% by weight or less, based on the total solids of the photosensitive layers.

Further, in the photosensitive lithographic printing plates never exposed to infrared light to near infrared light, the alkali-soluble polymers as described above are more preferably added in an amount of 30% to 80% by weight (most preferably 30 % to 70 % by weight), based on the total solids of the photosensitive layers. The amount added within this range are preferred in terms of development properties and press life.

Furthermore, for improving the ink-receptivity of images, it is preferred that condensation products with phenol-formaldehyde each having an alkyl group with 3 to 8 carbon atoms as a substituent group, such as t-butylphenolformaldehyde resins and octylphenol-formaldehyde resins, or o-naphthoquinone-diazidosulfonates of these condensation products (for example, ones described in JP-A-61-243446) are used in combination as described in U.S. Patent 4,123,279.

In the present invention, in addition to the above-mentioned respective components, the following components may be arbitrarily contained in coating solutions for the photosensitive layers containing the positive working photosensitive compounds.

### (Development Accelerators)

For increasing sensitivity and improving development properties, it is preferred that cyclic acid anhydrides, phenols and organic acids are added to the coating solutions for the photosensitive layers of the photosensitive lithographic printing plates of the present invention.

Examples of the cyclic acid anhydrides which can be used include phthalic anhydride, tetrahydrophthalic anhydride, hexahydro-phthalic anhydride, 3,6-endooxy-Δ⁴-tetrahydrophthalic anhydride, tetrachlorophthalic anhydride, maleic anhydride, chloromaleic anhydride, α-phenylmaleic anhydride, succinic anhydride and pyromellitic anhydride described in U.S. Patent 4,115,128.

Examples of the phenols include bisphenol A, p-nitrophenol, p-ethoxyphenol, 2,4,4'-trihydroxybenzophenone, 2,3,4-trihydroxybenzophenone, 4-hydroxybenzophenone, 4,4',4"-trihydroxytriphenylmethane and 4,4',3",4"-tetrahydroxy-3,5,3',5'-tetramethyltriphenylmethane.

Further, as the organic acids, sulfonic acids, sulfinic acids, alkylsulfuric acids, phosphonic acids, phosphates and carboxylic acids are described in JP-A-60-88942 and JP-A-2-96755. Specific examples thereof include p-toluenesulfonic acid, dodecylbenzenesulfonic acid, p-toluenesulfinic acid, ethylsulfuric acid, phenylphosphonic acid, phenylphosphinic acid, phenyl phosphate, diphenyl phosphate, benzoic acid, isophthalic acid, adipic acid, p-toluic acid, 3,4-dimethoxybenzoic acid, phthalic acid, terephthalic acid, 1,4-cyclohexene-2,2-dicaroxylic acid, erucic acid, lauric acid, n-undecanoic acid and ascorbic acid.

The above-mentioned cyclic acid anhydrides, phenols and organic acids are contained in an amount of preferably 0.05% to 15% by weight, more preferably 0.1% to 5% by weight, of the solids of the photosensitive layers.

### (Development Stabilizers)

For increasing processing stability to the development conditions (so-called development allowance), nonionic surfactants as described in JP-A-62-251740 and JP-A-4-68355 and amphoteric surfactants as described in JP-A-59-121044 and JP-A-4-13149 can be added to the coating solutions for the photosensitive layers of the photosensitive lithographic printing plates of the present invention.

Specific examples of the nonionic surfactants include sorbitan tristearate, sorbitan monopalmitate, sorbitan trioleate, stearic acid monoglyceride, polyoxyethylene sorbitan monooleate and polyoxyethylene nonyl phenyl ether.

Specific examples of the amphoteric surfactants include alkyldi(aminoethyl)glycines, alkylpolyaminoethylglycine hydrochlorides, 2-alkyl-N-carboxyethyl-N-hydroxyethyl-imidazoliniumbetaine, N-tetradecyl-N,N-betaine type surfactants (for example, Amorgen K (trade name) manufactured by Dai-ichi Kogyo Seiyaku Co., Ltd.) and alkylimidazoline surfactants (for example, Revon 15 (trade name) manufactured by Sanyo Chemical Industries, Ltd.).

The above-mentioned nonionic and amphoteric surfactants are contained in an amount of preferably 0.05% to 15% by weight, more preferably 0.1% to 5% by weight, of the solids of the photosensitive layers.

### (Print-out Agents, Dyes and Others)

Print-out agents for obtaining visible images immediately after exposure, dyes as image coloring agents, and others such as fillers can be added to the coating solutions for the photosensitive layers of the photosensitive lithographic printing plates of the present invention. The dyes which can be used in the present invention include basic dyes described in JP-A-5-313359 which are composed of salts of cations having skeleton (structure) of basic dyes and organic anions each having a sulfonic acid group as the only exchange group, 1 to 3 hydroxyl groups and 10 or more carbon atoms. The amount thereof added is from 0.2% to 5% by weight, based on the total solids of the photosensitive layers.

Further, compounds which interact with the dyes described in JP-A-5-313359 mentioned above to generate photodecomposed products changing hues, for example, o-naphthoquinonediazido-4-sulfonic acid halogenides described in JP-A-50-36209 (U.S. Patent 3,969,118), trihalomethyl-2-pyrone and trihalomethyl-triazine described in JP-A-53-36223 (U.S. Patent 4,160,671), various o-naphthoquinonediazide compounds described in JP-A-55-62444 (U.S. Patent 2,038,801) and 2-trihalomethyl-5-aryl-1,3,4-oxadiazole compounds described in JP-A-55-77742 (U.S. Patent 4,279,982), can also be added. These compounds can be used either alone or in combination. Of these compounds, compounds having absorption at 400 nm may be used as yellow dyes described later.

Besides the dyes described in JP-A-5-313359 described above, other dyes can also be used as the image coloring agents. As suitable dyes, oil-soluble dyes and basic dyes, including salt-forming organic dyes are exemplified. Specific examples thereof include Oil Green BG, Oil Blue BOS, Oil Blue #603 (manufactured by Orient Kagaku Kogyo Co., Ltd.), Victoria Pure Blue BOH, Victoria Pure Blue NAPS, Ethyl Violet 6HNAPS (manufactured by Hodogaya Chemical Co., Ltd.), Rhodamine B (C145170B), Malachite Green (C142000) and Methylene Blue (C152015).

Further, the following yellow dyes can be added to the coating solutions for the photosensitive layers of the photosensitive lithographic printing plates of the present invention.

Yellow dyes represented by formula [I], [II] or [III], in which the absorbance at 417 nm is 70% or more of the absorbance at 436 nm: 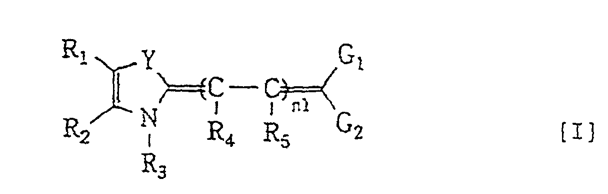 wherein R₁ and R₂, which may form a ring, each represents a hydrogen atom, an alkyl group having 1 to 10 carbon atoms, an aryl group or an alkenyl group; R₃, R₄ and R₅ each represents a hydrogen atom or an alkyl group having 1 to 10 carbon atoms; G₁ and C₂, which may form a ring, each represents an alkoxycarbonyl group, an aryloxycarbonyl group, an acyl group, an arylcarbonyl group, an alkylthio group, an arylthio group, an alkylsulfonyl group, an arylsulfonyl group or a fluoroalkyl-sulfonyl group; at least one of R₁, R₂, R₃, R₄, R₅, G₁ and G₂ has at least one sulfonic acid group, carboxyl group, sulfonamido group, imido group, N-sulfonylamido group, phenolic hydroxyl group, sulfonimido group or metal salt thereof, or inorganic or organic ammonium salt thereof; Y represents a divalent atomic group selected from the group consisting of 0, S, NR (R is a hydrogen atom, an alkyl group or an aryl group), Se, -C(CH₃)₂- and -CH=CH-; and n1 represents 0 or 1. 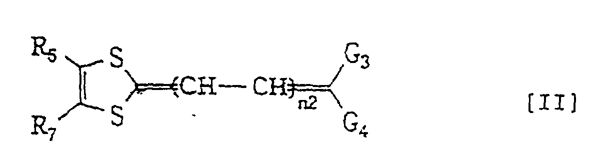 wherein R₆ and R₇, which may form a ring together with carbon atoms to which they are bound, each represents a hydrogen atom, an alkyl group, a substituted alkyl group, an aryl group, a substituted aryl group, a heterocyclic group, a substituted heterocyclic group, an allyl group or a substituted allyl group, n2 represents 0, 1 or 2; G₂ and G₄, which may form a ring composed of non-metallic atoms together with carbon atoms to which they are bound, each represents a hydrogen atom, a cyano group, an alkoxycarbonyl group, a substituted alkoxycarbonyl group, an aryloxycarbonyl group, a substituted aryloxy-carbonyl group, an acyl group, a substituted acyl group, an arylcarbonyl group, a substituted arylcarbonyl group, an alkylthio group, an arylthio group, an alkylsulfonyl group, an arylsulfonyl group or a fluoroalkylsulfonyl group, with the proviso that G₃ and G₄ are not hydrogen atoms at the same time; and at least one of R₆, R₇, G₃ and G₄ has at least one sulfonic acid group, carboxyl group, sulfonamido group, imido group, N-sulfonylamido group, phenolic hydroxyl group, sulfonimido group or metal salt thereof, or inorganic or organic ammonium salt thereof. 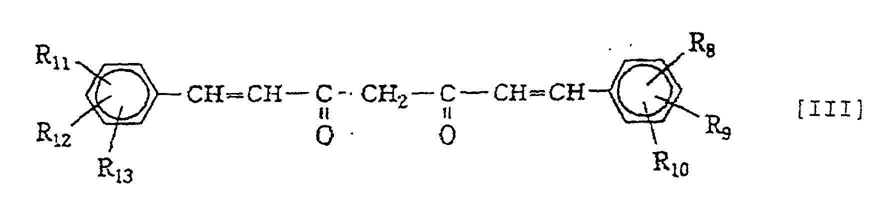 wherein R₈, R₉, R₁₀, R₁₁, R₁₂ and R₁₃, which may be the same or different, each represents a hydrogen atom, an alkyl group, a substituted alkyl group, an aryl group, a substituted aryl group, an alkoxyl group, a hydroxyl group, an acyl group, a cyano group, an alkoxycarbonyl group, an aryloxycarbonyl group, a nitro group, a carboxyl group, a chloro group or a bromo group.

### [Negative Working Photosensitive Compounds and Binders]

Further, negative working photosensitive compounds may be used as the photosensitive compounds of the present invention. Typical examples of the negative working photosensitive compounds include diazo resins. The diazo resins are ones represented by condensation products of aromatic diazonium salts and active carbonyl group-containing compounds such as formaldehyde.

The above-mentioned diazo resins include, for example, inorganic salts of organic solvent-soluble diazo resins which are reaction products of condensation products of p-diazodiphenylamines and aldehydes such as formaldehyde and acetaldehyde with hexafluorophosphates or tetrafluoroborates, and organic salts of organic solvent-soluble diazo resins which are reaction products of the above-mentioned condensation products with sulfonates such as p-toluene-sulfonic acid or salts thereof, propylnaphthalenesulfonic acid or salts thereof, butylnaphthalenesulfonic acid or salts thereof, dodecylbenzenesulfonic acid or salts thereof and 2-hydroxy-4-methoxybenzophenone-5-sulfonic acid or salts thereof, as described in JP-B-47-1167. They further include high molecular weight diazo compounds described in JP-A-59-78340.

Further, a mesitylenesulfonate obtained by condensing 3-methoxy-4-diazodiphenylamine with 4,4'-bismethoxymethyldiphenyl ether as described in JP-A-58-27141 is suitable.

Furthermore, as the diazo resins copolycondensates containing aromatic compounds each having at least one group of carboxyl, sulfonic acid, sulfinic acid, phosphoric oxygen acid and hydroxyl groups, and diazonium compounds, preferably aromatic diazonium compounds, as structure units are also exemplified.

Binders used together with the negative working photosensitive compounds are organic polymers having an acid content of 0.1 meq/g to 3.0 meq/g, preferably 0.2 meq/g to 2.0 meq/g, substantially insoluble in water (that is to say, insoluble in neutral or acidic aqueous solutions), dissoluble in or swellable with aqueous alkali developing solutions although having the film forming property, and photohardened in the coexistence of the above-mentioned photosensitive diazo resins to be insolubilized in or to become not swelled with the above-mentioned developing agents. An acid content of less than 0.1 meq/g results in the difficulty of developing, whereas exceeding 3.0 meq/g causes extremely decreased image strength in developing.

Particularly preferred examples of the binders include copolymers each containing acrylic acid, methacrylic acid, crotonic acid or maleic acid as an essential component, for example, multi-component copolymers each composed of 2-hydroxyethyl acrylate or 2-hydroxyethyl methacrylate, acrylonitrile or methacrylonitrile, acrylic acid or methacrylic acid, and optionally, another copolymerizable monomer, as described in JP-A-50-118802; multi-component copolymers each composed of acrylic acid or methacrylic acid esterified with a group having a hydroxyl group at its terminal and containing a dicarboxylate residue, acrylic acid or methacrylic acid, and optionally, another copolymerizable monomer, as described in JP-A-53-120903; multi-component copolymers each composed of a monomer having an aromatic hydroxyl group at its terminal (for example, N-(4-hydroxyphenyl)methacrylamide), acrylic acid or methacrylic acid, and optionally, another copolymerizable monomer, as described in JP-A-54-98614; and multi-component copolymers each composed of an alkyl acrylate, acrylonitrile or methacrylonitrile, and an unsaturated carboxylic acid, as described in JP-A-56-4144. Besides, acidic polyvinyl alcohol derivatives and acidic cellulose derivatives are also useful. Further, binders described in JP-B-54-19773, JP-A-57-94747, JP-A-60-182437, JP-A-62-58242 and JP-A-62-123453, which are obtained by alkali solubilizing polyvinyl acetal or polyurethane, are also useful. Furthermore, photo-crosslinkable polymers having maleimido groups at their side chains described in JP-B-5-2227 are also useful.

The contents of the diazo resins and the binders in the photosensitive layers of the photosensitive lithographic printing plates are suitably from 3% to 30% by weight for the diazo resins, and from 97% to 70% by weight for the binders, based on the total amount of both of them. The lower content of the diazo resins results in higher sensitivity. However, less than 3% by weight leads to insufficient photohardening of the binders, which causes photohardened films to be swelled with developing solutions in developing, resulting in formation of weak films. Conversely, a diazo resin content exceeding 30% by weight results in low sensitivity to provide disadvantages practically. Accordingly, the more preferred ranges are from 5% to 25% by weight for the diazo resins, and from 95% to 75% by weight for the binders.

### [Organic Solvents]

The photosensitive lithographic printing plates of the present invention can be obtained by coating the supports with the solutions of the above-mentioned fluorine based copolymers purified, photosensitive compounds and binders, and optionally other components, in the organic solvents, followed by drying.

The organic solvents for dissolving the respective components are described below.

Specific examples of the solvents which can be properly selected and used include γ-butyrolactone, ethylene dichloride, cyclohexanone, methyl ethyl ketone, ethylene glycol monomethyl ether, ethylene glycol monoethyl ether, 2-methoxyethyl acetate, 1-methoxy-2-propanol, 1-methoxy-2-propyl acetate, toluene, ethyl acetate, methyl lactate, ethyl lactate, dimethyl sulfoxide, dimethylacetamide, dimethylformamide, water, N-methylpyrrolidone, tetrahydrofurfuryl alcohol, acetone, diacetone alcohol, methanol, ethanol, isopropanol, diethylene glycol dimethyl ether and mixtures thereof.

The components such as the photosensitive compounds, the binders, the fluorine based copolymers and the other optional additives are dissolved in the above-mentioned coating solvents. The solid concentration of the coating solutions for the photosensitive layers in coating is suitably from 1.0% to 50% by weight, and more preferably from 2.0% to 30% by weight.

The above-mentioned coating solutions are applied onto the aluminum supports having hydrophilic surfaces so as to give a dry coated weight of 0.3 g/m² to 5.0 g/m², preferably from 0.5 g/m² to 4.0 g/m², and dried, thereby being able to obtain the photosensitive lithographic printing plates. Less than 0.5 g/m² results in deteriorated press life, whereas exceeding 4.0 g/m² improves press life, but results in a reduction in sensitivity.

As methods for coating the supports with the coating solutions for the photosensitive layers, conventionally well-known methods such as rod coating, roll coating, bar coating, spray coating, curtain coating and rotary coating can be used. The solutions applied are preferably dried at 50°C to 150°C. As drying methods, the solutions may be first pre-dried at low temperature, followed by drying at high temperature, or may be directly dried at high temperature.

The supports used in the photosensitive lithographic printing plates of the present invention and treatments thereof are described below.

### [Supports]

Examples of the supports of the photosensitive lithographic printing plates of the present invention include aluminum plates. The aluminum plates may be tabular materials plated of pure aluminum or aluminum alloys mainly composed of aluminum and containing a slight amount of foreign elements. The foreign elements include silicon, iron, manganese, copper, magnesium, chromium, zinc, bismuth, nickel and titanium. As the alloy composition, the content of the foreign elements is 10% by weight or less. Aluminum suitable for the present invention is pure aluminum. However, it is difficult for refining technology to produce completely pure aluminum, so that aluminum preferably contains foreign elements as slightly as possible. The aluminum alloys having a foreign element-content as described above can be said to be materials which can be used in the present invention. Thus, the aluminum plates to which the coating solutions of the present invention are applied are not particularly specified in composition, and materials conventionally well-known or used can be appropriately utilized. Preferred examples of the materials include JIS A 1050, JIS A 1100, JIS A 1200, JIS A 3003, JIS A 3103 and JIS A 3005 materials. The thickness of the aluminum plates is from about 0.1 mm to about 0.6 mm. Prior to surface roughening (i.e., graining) of the aluminum plates, for removing rolling oil on surfaces thereof, for example, degreasing treatment is conducted by use of surface active agents or alkaline aqueous solutions if desired.

### (Surface Roughening (i.e., Graining) Treatment and Anodic Oxidization Treatment)

Examples of methods for roughening the surfaces of the aluminum plates include methods of mechanically roughening (i.e., graining) the surfaces, methods of electrochemically roughening (i.e., graining) the surfaces by dissolution and methods of chemically selectively dissolving the surfaces. As the mechanical methods, well-known methods such as ball polishing, brushing, blasting and buffing can be used. The electrochemical roughening (i.e., graining) methods include methods of roughening (i.e., graining) the surfaces in electrolytic solutions of hydrochloric acid or nitric acid with alternating current or direct current. As described in JP-A-54-63902, methods in which both are combined can also be utilized.

The aluminum plates thus roughened (i.e., grained) are subjected to alkali etching treatment and neutralizing treatment as required, followed by anodic oxidization treatment for enhancing the water receptivity (i.e., ater retention) and the wear resistance of the surfaces. As electrolytes used in anodic oxidization treatment of the aluminum plates, any electrolytes can be used as long as they form porous oxide films. In general, sulfuric acid, phosphoric acid, oxalic acid, chromic acid and mixed acids thereof can be used. The concentration of the electrolytes can be appropriately determined depending on the kind of electrolyte.

The conditions of anodic oxidation treatment can not be specified, because they vary depending on the kind of electrolyte used. However, an electrolyte concentration within the range of 1% to 80%, a solution temperature within the range of 5°C to 70°C, a current density within the range of 5 A/dm² to 60 A/dm², a voltage within the range of 1 V to 100 V and an electrolytic time within the range of 10 seconds to 5 minutes are generally suitable.

The amount of anodic oxide films is suitably 1.0 g/m² or more, and more preferably within the range of 2.0 g/m² to 6.0 g/m². Less than 1 g/m² results in insufficient press life or easy development of scratches in non-image areas of the lithographic printing plates, which causes a tendency to form so-called "scratching stains" due to adhesion of ink to the scratches in printing.

Such anodic oxidation treatment is applied to a surface used for printing of the support of the lithographic printing plate. However, 0.01 g/m² to 3 g/m² of an anodic oxide film is also generally plated on the other side by back flowing of electric lines of force.

### (Hydrophilization Treatment)

As hydrophilization treatment used after the above-mentioned treatment, hydrophilization treatment which has hitherto been known is used. Examples of such hydrophilization treatment includes an alkali metal silicate (for example, an aqueous solution of sodium silicate) process as described in U.S. Patents 2,714,066, 3,181,461, 3,280,734 and 3,902,734. In this process, the support is immersed or electrolyzed in the aqueous solution of sodium silicate. In addition, a process of treating the support with potassium fluorozirconate disclosed in JP-B-36-22063, or polyvinylphosphonic acid as disclosed in U.S. Patents 3,276,868, 4,153,461 and 4,689,272 is used.

Of these, particularly preferred in the present invention is the silicate treatment.

The silicate treatment is described below.

### (Silicate Treatment)

The anodic oxide films of the aluminum plates treated as described above are immersed in aqueous solutions containing 0.001% to 30% by weight, preferably 0.05% to 10% by weight of alkali metal silicates and having a pH of 9 to 13 at 25°C, for example, at 5°C to 80°C for 0.5 second to 120 seconds. If the pH of the aqueous solutions of alkali metal silicates is lower than 9, gelation of the solutions takes place. On the other hand, exceeding 13.0 results in dissolution of the oxide films. Examples of the alkali metal silicates used in the present invention include sodium silicate, potassium silicate and lithium silicate. Examples of hydroxides used for increasing the pH of the aqueous solutions of alkali metal silicates include sodium hydroxide, potassium hydroxide and lithium hydroxide. To the above-mentioned treating solutions, alkaline earth metal salts or salts of the group IVB metals in the periodic table may be added. Examples of the alkaline earth metal salts include water-soluble salts such as nitrates, for example, calcium nitrate, strontium nitrate, magnesium nitrate and barium nitrate, sulfates, hydrochlorides, phosphates, acetates, oxalates and borates. Examples of the salts of the group IVB metals include titanium tetrachloride, titanium trichloride, fluorinated potassium titanium, potassium titanium oxalate, titanium sulfate, titanium tetraiodide, zirconium chloride oxide, zirconium dioxide, zirconium oxychloride and zirconium tetrachloride. The alkaline earth metal salts or the salts of the group IVB metals can be used either alone or as a combination of two or more of them. The amount of these metal salts ranges preferably from 0.10% to 10% by weight, more preferably from 0.05% to 5.0% by weight.

The hydrophilicity of the aluminum plate surfaces is further improved by the silicate treatment, so that ink becomes hard to adhere to the non-image areas to improve the stain prevention performance.

### (Under Coating)

Further, aluminum supports may be undercoated.

Examples of compounds preferably used in under coating include, for example, carboxymethyl cellulose, dextrin, gum arabic, amino group-containing phosphonic acids such as 2-aminoethyl-phosphonic acid, organic phosphonic acids which may have substituent groups, such as phenylphosphonic acid, naphthyl-phosphonic acid, alkylphosphonic acids, glycerophosphonic acid, methylenediphosphonic acid and ethylenediphosphonic acid, organic phosphoric acids which may have substituent groups, such as phenylphosphoric acid, naphthylphosphoric acid, alkylphosphoric acids and glycerophosphoric acid, organic phosphinic acids which may have substituent groups, such as phenylphosphinic acid, naphthylphosphinic acid, alkylphosphinic acids and glycerophosphinic acid, amino acids such as glycine and β-alanine, hydroxyl group-containing amine hydrochlorides, such as triethanolamine hydrochlorides, sulfonic acid group-containing water-soluble polymers described in JP-A-59-101651, and acid dyes described in JP-A-60-64352.

The undercoat layers can be provided by dissolving the above-mentioned compounds in water, methanol, ethanol, methyl ethyl ketone or mixed solvents thereof, applying the resulting solutions onto the supports, and drying them. For improving the tone reproduction of the photosensitive lithographic printing plates, yellow dyes can also be added.

The amount of the undercoat layers coated and dried is suitably from 2 mg/m² to 200 mg/m², and preferably from 5 mg/m² to 100 mg/m².

### (Backcoats)

Backcoats may be plated on the back sides of the supports as so required. Coating layers comprising organic polymers described in JP-A-5-45885 and metal oxides obtained by hydrolysis and polycondensation of organic or inorganic metal compounds described in JP-A-6-35174 are preferably provided as such backcoats.

Of these coating layers, alkoxy compounds of silicon such as Si(OCH₃)₄, Si(OC₂H₅)₄, Si(OC₃H₇)₄ and Si(OC₄H₉)₄ are particularly preferred, because they are inexpensive and easily available, and the coating layers of metal oxides given are excellent in resistance to development.

As described above, the photosensitive lithographic printing plates of the present invention are prepared by coating the supports subjected to any hydrophilization treatment with the solutions containing the fluorine based copolymers purified, the photosensitive compounds, the binders, the organic solvent and the other optional components, followed by drying. The resulting photosensitive lithographic printing plates are subjected to processing steps such as image exposure, development and printing. These processing steps are described with reference to typical examples for illustration, but are not limited thereto.

### (Exposure)

The photosensitive lithographic printing plates of the present invention are image exposed, followed by development processing. Examples of light sources of active light rays used in image exposure include carbon arc lamps, mercury lamps, metal halide lamps, xenon lamps, tungsten lamps and chemical lamps. Examples of radiations include electron beams, X-rays, ion beams and far infrared rays. Further, g-rays, i-rays, deep-UV rays and high density energy beams (laser beams) are also used. Examples of the laser beams include helium-neon laser beams, argon laser beams, krypton laser beams, helium-cadmium laser beams, KrF excimer laser beams, semiconductor laser beams and YAG laser beams.

### (Developing Solutions)

As developing solutions for the positive working photosensitive lithographic printing plates, alkaline aqueous solutions substantially free from organic solvents are usually used. Specifically, aqueous solutions of sodium silicate, potassium silicate, NaOH, KOH, LiOH, sodium tertiary phosphate, sodium secondary phosphate, ammonium tertiary phosphate, ammonium secondary phosphate, sodium metasilicate, sodium carbonate, sodium bicarbonate, potassium carbonate and aqueous ammonia are suitable. Further, (a) at least one sugar selected from nonreducing sugars and (b) at least one base may be contained. It is preferred that the pH ranges from 9.0 to 13.5.

The nonreducing sugars are sugars having no free aldehyde and ketone groups and showing no reducing properties, and classified into trehalose type oligosaccharides in which reducing groups combine with each other, glycosides in which reducing groups of sugars combine with nonsugars, and sugar alcohols obtained by reduction of sugars by hydrogen addition. They are all suitably used. Examples of the trehalose type oligosaccharides include saccharose and trehalose, and examples of the glycosides include alkyl glycosides, phenol glycosides and mustard oil glycosides. Further, examples of the sugar alcohols include D, L-arabitol, ribitol, xylitol, D, L-sorbitol, D, L-mannitol, D, L-iditol, D, L-talitol, dulcitol and allodulcitol. Furthermore, maltitols obtained by hydrogen addition of disaccharides and reduced products (reduced starch syrup) obtained by hydrogen addition of oligosaccharides are preferably used. Of these, particularly preferred nonreducing sugars are sugar alcohols and saccharose, and particularly, D-sorbitol, saccharose and reduced starch syrup are preferred in terms of buffering action within an appropriate pH range and low cost.

These nonreducing sugars may be used either alone or as a combination of two or more of them, and are contained in an amount of preferably 0.1% to 30% by weight, more preferably 1% to 20% by weight, of the developing solutions. Less than this range results in failure to obtain sufficient buffering action, whereas exceeding this range leads to difficulty in highly concentrating them, and introduces the problem of a rise in cost.

As the bases combined with the nonreducing sugars, conventionally well-known alkali agents can be used. Examples thereof include inorganic alkali agents such as sodium hydroxide, potassium hydroxide, lithium hydroxide, trisodium phosphate, tripotassium phosphate, triammonium phosphate, disodium phosphate, dipotassium phosphate, diammonium phosphate, sodium carbonate, potassium carbonate, ammonium carbonate, sodium hydrogencarbonate, potassium hydrogencarbonate, ammonium hydrogencarbonate, sodium borate, potassium borate and ammonium borate. Further, organic alkali agents such as monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanol-amine, monoisopropanolamine, diisopropanolamine, ethyleneimine, ethylenediamine and pyridine are also used.

These alkali agents are used either alone or as a combination of two or more of them. Of these, preferred are sodium hydroxide and potassium hydroxide. The reason for this is that the pH adjustment becomes possible in a wide pH region by adjustment of the amount of them to the nonreducing sugars. Further, trisodium phosphate, tripotassium phosphate, sodium carbonate and potassium carbonate are also preferred because they themselves have buffering action.

These alkali agents are added so that the developing solutions have a pH ranging from 9.0 to 13.5, and the amount thereof added is determined according to the desired pH, the kind of nonreducing sugar and the amount thereof added. However, the pH range is more preferably from 10.0 to 13.2.

Further, in the developing solutions, weak acids other than the sugars can be used in combination with alkali buffer solutions comprising strong bases. As the weak acids used as such buffer solutions, acids having a pKa of 10.0 to 13.2 are preferred. Such weak acids are selected from ones described in Ionization Constants of Organic Acids in Aqueous Solution published by Pergamon Press, and examples thereof include, for example, alcohols such as 2,2,3,3-tetrafluoropropanol-1 (pKa 12.74), trifluoroethanol (pKa 12.37) and trichloroethanol (pKa 12.24); aldehydes such as pyridine-2-aldehyde (pKa 12.68) and pyridine-4-aldehyde (pKa 12.05); phenolic hydroxyl group-containing compounds such as salicylic acid (pKa 13.0), 3-hydroxy-2-naphthoic acid (pKa 12.84), catechol (pKa 12.6), gallic acid (pKa 12.4), sulfosalicylic acid (pKa 11.7), 3,4-dihydroxysulfonic acid (pKa 12.2), 3,4-dihydroxybenzoic acid (pKa 11.94), 1,2,4-trihydroxybenzene (pKa 11.82), hydroquinone (pKa 11.56), pyrogallol (pKa 11.34), o-cresol (pKa 10.33), resorcinol (pKa 11.27), p-cresol (pKa 10.27) and m-cresol (pKa 10.09); oximes such as 2-butanone oxime (pKa 12.45), acetoxime (pKa 12.42), 1,2-cycloheptanedione dioxime (pKa 12.3), 2-hydroxybenzaldehyde oxime (pKa 12.10), dimethylglyoxime (pKa 11.9), ethanediamidodioxime (pKa 11.37) and acetophenone oxime (pKa 11.35); and nucleic acid-relating substances such as adenosine (pKa 12.56), inosine (pKa 12.5), guanine (pKa 12.3), cytosine (pKa 12.2), hypoxanthine (pKa 12.1) and xanthine (pKa 11.9). In addition, they further include weak acids such as diethylaminomethylphosphonic acid (pKa 12.32), 1-amino-3,3,3-trifluorobenzoic acid (pKa 12.29), isopropylidenediphosphonic acid (pKa 12.10), 1,1-ethylidenediphosphonic acid (pKa 11.54), 1,1-ethylidenediphosphonic acid 1-hydroxy (pKa 11.52), benzimidazole (pKa 12.86), thiobenzamide (pKa 12.8), picolinethioamide (pKa 12.55) and barbituric acid (pKa 12.5).

Of these weak acids, preferred are sulfosalicylic acid and salicylic acid.

As the bases combined with these weak acids, sodium hydroxide, ammonium hydroxide, potassium hydroxide and lithium hydroxide are properly used.

These alkali agents are used either alone or as a combination of two or more of them.

The above-mentioned various alkali agents are used after adjustment of the pH within a preferred range by the concentration and combination thereof.

For accelerating the development properties, and enhancing dispersion of development scum and the ink affinity (i.e., the ink receptivity) of image areas of the printing plates, various surfactants and organic solvents can be added as required. Preferred examples of the surfactants include anionic, cationic, nonionic and amphoteric surfactants.

Preferred examples of the surfactants include nonionic surfactants such as polyoxyethylene alkyl ethers, polyoxyethylene alkyl phenyl ethers, polyoxyethylene polystyryl phenyl ethers, polyoxyethylene polyoxypropylene alkyl ethers, glycerol fatty acid partial esters, sorbitan fatty acid partial esters, pentaerythritol fatty acid partial esters, propylene glycol fatty acid monoesters, sucrose fatty acid partial esters, polyoxyethylene sorbitan fatty acid partial esters, polyoxyethylene sorbitol fatty acid partial esters, polyethylene glycol fatty acid esters, polyglycerol fatty acid partial esters, polyoxyethylenized caster oils, polyoxyethylene glycerol fatty acid partial esters, fatty acid diethanolamides, N,N-bis-2-hydroxyalkylamines, polyoxyethylenealkylamines, triethanolamine fatty acid esters and trialkylamine oxides; anionic surfactants such as fatty acid salts, abietates, hydroxyalkanesulfonates, alkanesulfonates, dialkylsulfosuccinic acid ester, straight chain alkylbenzenesulfonates, branched chain alkylbenzenesulfonates, alkylnaphthalenesulfonates, alkylphenoxypolyoxyethylenepropylsulfonates, polyoxyethylenealkylsulfophenyl ether salts, N-methyl-N-oleyltaurine sodium salt, N-alkylsulfosuccinic acid monoamide disodium salts, petroleum sulfonic acid salts, sulfated tallow, fatty acid alkyl ester sulfates, alkylsulfates, polyoxyethylene alkyl ether sulfates, fatty acid monoglyceride sulfates, polyoxyethylene alkyl phenyl ether sulfates, polyoxyethylene styryl phenyl ether sulfates, alkyl phosphates, polyoxyethylene alkyl ether phosphates, polyoxyethylene alkyl phenyl ether phosphates, partially saponified products of styrene/maleic anhydride copolymers, partially saponified products of olefin/maleic anhydride copolymers and formalin-condensed products of naphthalenesulfonates; cationic surfactants such as alkylamine salts, quaternary ammonium salts such as tetrabutylammonium bromide, polyoxyethylenealkylamine salts and polyethylenepolyamine derivatives; and amphoteric surfactants such as carboxybetaines, aminocarboxylic acids, sulfobetaines, aminosulfates and imidazolines.

In the surfactants described above, "polyoxyethylene" can also be read as a polyoxyalkylene such as polyoxymethylene, polyoxypropylene or polyoxybutylene, and such surfactants are also included.

Further, fluorine based surfactants containing perfluoroalkyl groups in their molecules are also preferred. Such fluorine surfactants include anionic surfactants such as perfluoroalkylcarboxylates, perfluoroalkylsulfonates and perfluoroalkylphosphates; amphoteric surfactants such as perfluoroalkylbetaines; cationic surfactants such as perfluoroalkyltrimethylammonium salts; and nonionic surfactants such as perfluoroalkylamine oxides, perfluoroalkyl ethylene oxide adducts, oligomers containing perfluoroalkyl groups and hydrophilic groups, oligomers containing perfluoroalkyl groups and lipophilic groups, oligomers containing perfluoroalkyl groups, hydrophilic groups and lipophilic groups, and urethanes containing perfluoroalkyl groups and lipophilic groups.

The above-mentioned surfactants can be used either alone or as a combination of two or more of them, and are added to the developing solutions within the range of 0.001% to 10% by weight, more preferably within the range of 0.01% to 5% by weight.

Various development stabilizers are used in the developing solutions. Preferred examples thereof include polyethylene glycol adducts of sugar alcohols described in JP-A-6-282079, tetraalkylammonium salts such as tetrabutylammonium hydroxide, phosphonium salts such as tetrabutylphosphonium bromide, and iodonium salts such as diphenyliodonium chloride.

They further include anionic surfactants or amphoteric surfactants described in JP-A-50-51324, water-soluble cationic polymers described in JP-A-55-95946 and water-soluble amphoteric polyelectrolytes described in JP-A-56-142528.

Furthermore, they include alkylene glycol-added organic boron compounds described in JP-A-59-84241, polyoxyethylene-polyoxypropylene block copolymerization type water-soluble surfactants described in JP-A-60-111246, polyoxyethylene-polyoxypropylene-substituted alkylenediamine compounds described in JP-A-60-129750, polyethylene glycol having a weight average molecular weight of 300 or more described in JP-A-61-215554, fluorine-containing surfactants having cationic groups described in JP-A-63-175858, water-soluble ethylene oxide addition compounds obtained by adding 4 moles or more of ethylene oxide to acids or alcohols described in JP-A-2-39157, and water-soluble polyalkylene compounds.

The developing solutions are substantially free from organic solvents. However, organic solvents are added thereto if necessary. Such organic solvents suitably have a solubility in water of about 10% by weight or less, and are preferably selected from ones having a solubility of 5% by weight or less. Examples thereof include 1-phenylethanol, 2-phenylethanol, 3-phenyl-1-propanol, 4-phenyl-1-butanol, 4-phenyl-2-butanol, 2-phenyl-1-butanol, 2-phenoxyethanol, 2-benzyloxyethanol, o-methoxybenzyl alcohol, m-methoxybenzyl alcohol, p-methoxybenzyl alcohol, benzyl alcohol, cyclohexanol, 2-methylcyclohexanol, 3-methylcyclohexanol, 4-methylcyclohexanol, N-phenylethanolamine and N-phenyl-diethanolamine. In the developing solutions usable in the photosensitive lithographic printing plate of the present invention, the term "substantially free from organic solvents" means that the content of the organic solvents is 5% by weight or less, based on the total weight of the solution used. The amount thereof used is closely related to the amount of the surfactants used, and it is preferred that the amount of the surfactants is increased with an increase in the amount of the organic solvents. This is because if the surfactants are used in small amounts and the organic solvents are used in large amounts, the organic solvents are not completely dissolved, resulting in failure to expect to ensure good development properties.

Reducing agents can be further added to the developing agents, which prevents the printing plates from being stained. In particular, this is effective in developing negative working photosensitive lithographic printing plates containing photosensitive diazonium salt compounds. Preferred examples of the organic reducing agents include phenol compounds such as thiosalicylic acid, hydroquinone, Metol, methoxyquinone, resorcin and 2-methylresorcin, and amine compounds such as phenylenediamine and phenylhydrazine. Further preferred examples of the inorganic reducing agents include sodium salts, potassium salts and ammonium salts of inorganic acids such as sulfurous acid, hydrogensulfurous acid, phosphorous acid, hydrogenphosphorous acid, dihydrogenphosphorous acid, thiosulfuric acid and dithionous acid. Of these reducing agents, particularly excellent in stain prevention effect are sulfites. These reducing agents are preferably contained within the range of 0.05% to 5% by weight, based on the developing solution at the time of use.

Organic carboxylic acids can be further added to the developing solutions. The organic carboxylic acids are preferably aliphatic and aromatic carboxylic acids each having 6 to 20 carbon atoms. Specific examples of the aliphatic carboxylic acids include caproic acid, enanthylic acid, caprylic acid, lauric acid, myristic acid, palmitic acid and stearic acid, and particularly, alkanoic acids each having 8 to 12 carbon atoms are preferred. Further, they may be unsaturated fatty acids having either double bonds in carbon chains or branched carbon chains.

The aromatic carboxylic acids are compounds in which benzene rings, naphthalene rings and anthracene rings have carboxyl groups as substituent groups, and specific examples thereof include o-chlorobenzoic acid, p-chlorobenzoic acid, o-hydroxybenzoic acid, p-hydroxybenzoic acid, o-aminobenzoic acid, p-aminobenzoic acid, 2,4-dihydroxybenzoic acid, 2,5-dihydroxybenzoic acid, 2,6-dihydroxybenzoic acid, 2,3-dihydroxybenzoic acid, 3,5-dihydroxybenzoic acid, gallic acid, 1-hydroxy-2-naphthoic acid, 3-hydroxy-2-naphthoic acid, 2-hydroxy-1-naphthoic acid, 1-naphthoic acid and 2-naphthoic acid. The hydroxynaphthoic acids are particularly effective.

The above-mentioned aliphatic and aromatic carboxylic acids are preferably used as sodium salts, potassium salts or ammonium salts for enhancing water solubility. There is no particular limitation on the content of the organic carboxylic acids in the developing solutions used in the present invention. However, less than 0.1% by weight results in insufficient effect, whereas exceeding 10% by weight not only results in failure to more improve the effect, but also sometimes prevents other additives from being dissolved when they are used in combination. Accordingly, the amount added is preferably 0.1% to 10% by weight, and more preferably 0.5% to 4% by weight, based on the developing solution at the time of use.

The developing solutions can also further contain preservatives, coloring agents, thickeners, antifoaming agents and hard water softeners as required. Examples of the hard water softeners include polyphosphoric acids, and sodium salts, potassium salts and ammonium salts thereof; aminopolycarboxylic acids such as ethylenediaminetetraacetic acid, diethylenetriaminepentaacetic acid, triethylene-tetraminehexaacetic acid, hydroxyethylethylenediamine-triacetic acid, nitriloacetic acid, 1,2-diaminocyclohexane-tetraacetic acid and 1,3-diamino-2-propanoltetraacetic acid, and sodium salts, potassium salts and ammonium salts thereof; and aminotri(methylenephosphonic acid), ethylenediaminetetra- (methylenephosphonic acid), diethylenetriaminepenta-(methylenephosphonic acid), triethylenetetraminehexa-(methylenephosphonic acid), hydroxyethylethylenediaminetri(methylenephosphonic acid) and 1-hydroxyethane-1,1-diphosphonic acid, and sodium salts, potassium salts and ammonium salts thereof.

Although the optimum value of such hard water softeners varies according to their chelating power, and the hardness and amount of hard water used, the usual amount thereof used ranges from 0.01% to 5% by weight, and more preferably from 0.01% to 0.5% by weight, based on the developing solution at the time of use. If the amount added is less than this range, the desired objects are not sufficiently attained. On the other hand, if the amount added is more than this range, adverse effect is exerted on image areas such as blank color areas (e.g., clear spots).

The residual component of the developing solution is water. In respect to transportation, it is advantageous to dilute a concentrated solution whose water content is less than that at the time of use, with water at the time of use. For the concentrated degree in this case, such a degree that the respective components are not separated or precipitated is suitable.

As the developing solution for the photosensitive lithographic printing plate of the present invention, a developing solution described in JP-A-6-282079 can also be used. This developing solution is a developing solution containing a water-soluble ethylene oxide addition compound obtained by adding 5 moles or more of ethylene oxide to an alkali metal silicate having a SiO₂/M₂O (wherein M represents an alkali metal) molar ratio of 0.5 to 2.0 and a sugar alcohol having 4 or more of hydroxyl groups. The sugar alcohols are polyhydric alcohols corresponding to sugars in which aldehyde groups and ketone groups are converted to primary and secondary alcohol groups, respectively. Specific examples of the sugar alcohols include D, L-threitol, erythritol, D, L-arabitol, ribitol, xylitol, D, L-sorbitol, D, L-mannitol, D, L-iditol, D, L-talitol, dulcitol and allodulcitol, and further include di, tri, tetra, penta and hexaglycerols obtained by condensation of the sugar alcohols. The above-mentioned water-soluble ethylene oxide addition compounds are each obtained by adding 5 moles or more of ethylene oxide to 1 mole of the above-mentioned sugar alcohol. Further, propylene oxide may be block copolymerized with the ethylene oxide addition compounds as required, as long as the solubility is allowable. These ethylene oxide addition compounds may be used either alone or as a combination of two or more of them.

The amount of these water-soluble ethylene oxide addition compounds added is suitably from 0.001% to 5% by weight, and more preferably from 0.001% to 2% by weight, based on the developing solution (working solution).

For accelerating the development properties, and enhancing dispersion of development scum and the ink affinity (i.e., the ink receptivity) of image areas of the printing plates, the above-mentioned various surfactants and organic solvents can be added as required.

The aqueous alkali developing solutions used for development of the negative working photosensitive printing plates are developing solutions as described in JP-A-51-77401, JP-A-51-80228, JP-A-53-44202 and JP-A-55-52054, and the solutions having a pH of 8 to 13 and a water content of 75% or more by weight are preferred. Organic solvents the solubility of which in water at ordinary temperature is 10% or less by weight (benzyl alcohol and ethylene glycol monophenyl ether), alkali agents (triethanolamine, diethanolamine, monoethanolamine, sodium phosphate and sodium carbonate), anionic surfactants (aromatic sulfonates, dialkyl sulfosuccinates, alkyl naphthalenesulfonates, fatty acid salts and alkyl sulfates), nonionic surfactants (polyoxyethylene alkyl ethers, polyoxyethylene alkyl aryl ethers and polyoxyethylene-polyoxypropylene block polymers), stain inhibitor (sodium sulfite and sodium salt of pyrazolone) and hard water softeners (tetrasodium ethylenediaminetetraacetate and trisodium nitrotriacetate) can be added if necessary.

However, the inclusion of organic solvents and the like raises hygienic problems such as toxicity and bad odors in working, problems of safety such as fires and gas explosions, problems of workability such as development of bubbles, problems of pollution due to waste water and a problem with regard to cost. It is therefore more preferred that the developing solutions are substantially free from organic solvents.

As such aqueous alkali developing solutions substantially free from organic solvents, for example, developing solution compositions described in JP-A-59-84241, JP-A-57-192952 and JP-A-62-24263, which are used in developing the positive working lithographic printing plates after image exposure, can be used.

### (Plate-making Processing)

After development processing using the development processing solutions as described above, the photosensitive lithographic printing plates of the present invention may be subjected to plate-making processing by methods described in JP-A-54-8002, JP-A-55-115045 and JP-A-59-58431. That is to say, after development processing, they may be subjected to desensitizing processing after washing with water, desensitizing processing directly as such, processing with aqueous solutions containing acids, or desensitizing processing after processing with aqueous solutions containing acids.

Further, in this kind of development step of the photosensitive lithographic printing plates, aqueous alkali solutions are consumed according to the amount of the printing plates processed to decrease the alkali concentration, or the long operation of automatic processors decreases the alkali concentration by air to reduce processing capacity. In that case, the processing capacity may be restored by using replenishers as described in JP-A-54-62004. In this case, the replenishers are preferably replenished by methods described in U.S. Patent 4,882,246.

Furthermore, the prepress processing as described above is preferably carried out with automatic processors as described in JP-A-2-7054 and JP-A-2-32357.

Desensitizing gum applied at the final step of the plate-making processing steps is preferably one described in JP-B-62-16834, JP-B-62-25118, JP-B-63-52600, JP-A-62-7595, JP-A-62-11693 and JP-A-62-83194.

After processing with the developing solutions, unnecessary portions of image areas can also be erased with commercially available negative eliminator, or rubbed out with stone rods.

### (Development and After-Treatment)

The PS plates processed with the developing solutions having such composition are after-treated with washing water, rinsing solutions containing surfactants, finishers mainly composed of gum arabic and starch derivatives, and protective gum solutions. For the after-treatment of the PS plates of the present invention, these treatments can be used in various combinations.

Recently, in the plate-making processing and printing industries, automatic processors for PS plates have been widely used for rationalization and standardization of plate-making processing operations. This automatic processor generally comprises a development unit, an after-treatment unit, a device for transporting a PS plate, respective processing solution tanks and sprays, and respective pumped-up processing solutions are sprayed on the exposed PS plate from spray nozzles while horizontally transporting the PS plate to conduct development and after-treatment. Further, recently, a process of immersing and transporting a PS plate in a processing tank filled with a processing solution by means of guide rolls provided in the solution to conduct development processing, and a process of supplying a small constant amount of washing water to a plate surface after development to wash it with water, and recycling the waste water as diluent water for a stock solution of a developing solution have also been known.

In such automatic processing, processing can be perplated while replenishing each replenisher to each processing solution depending on the processing amount and operating time. Further, a so-called throw-away processing system in which a plate is processed with a substantially virgin processing solution can also be applied.

The lithographic printing plates obtained by such processing are set on an offset press to print a number of sheets.

The present invention will be described with reference to examples in detail below. All percentages and parts in the following examples are by weight, unless otherwise specified.

### PURIFICATION EXAMPLES 1 TO 5 AND COMPARATIVE PURIFICATION EXAMPLE 1

Solutions of crude fluorine based copolymers described in Table 1 in solvents shown in Table 2 were allowed to stand still under the conditions of temperature and time described in Table 2, and filtered under pressure using filters described in Table 2, thereby purifying the fluorine based copolymers.

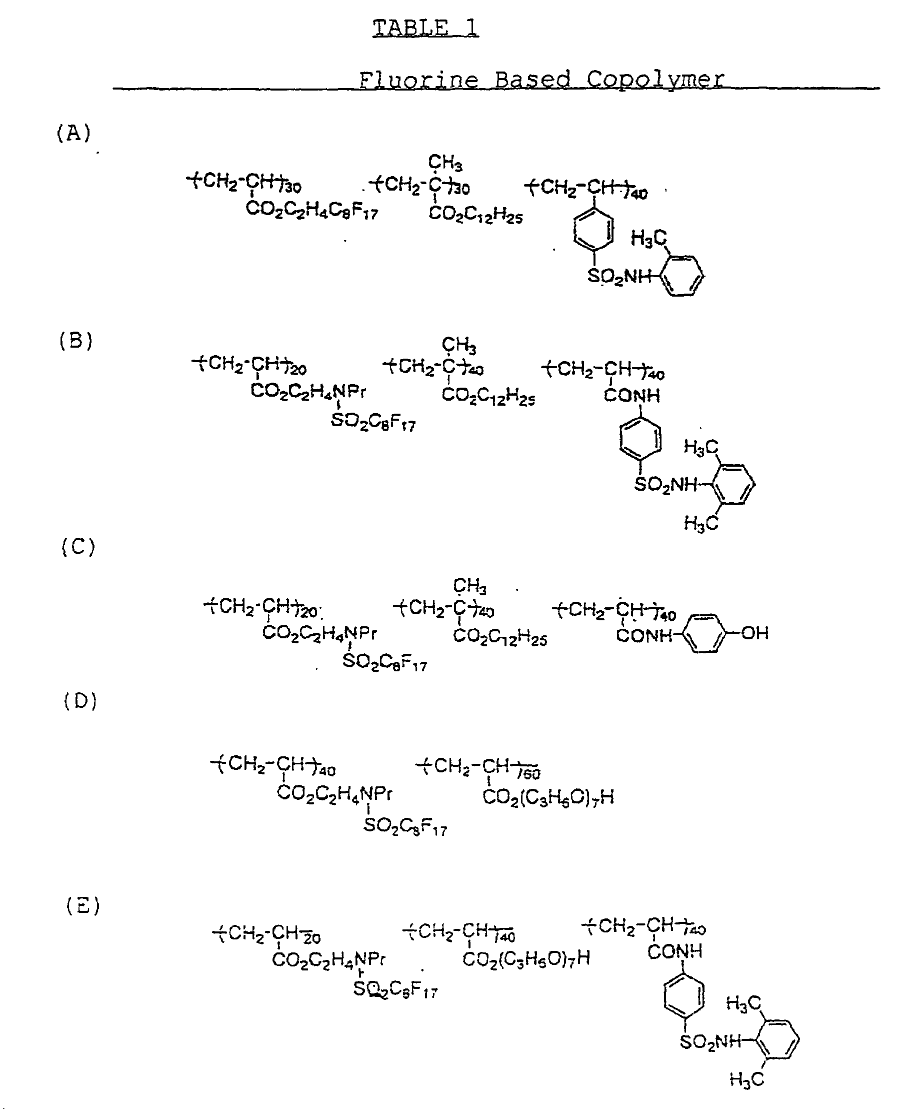

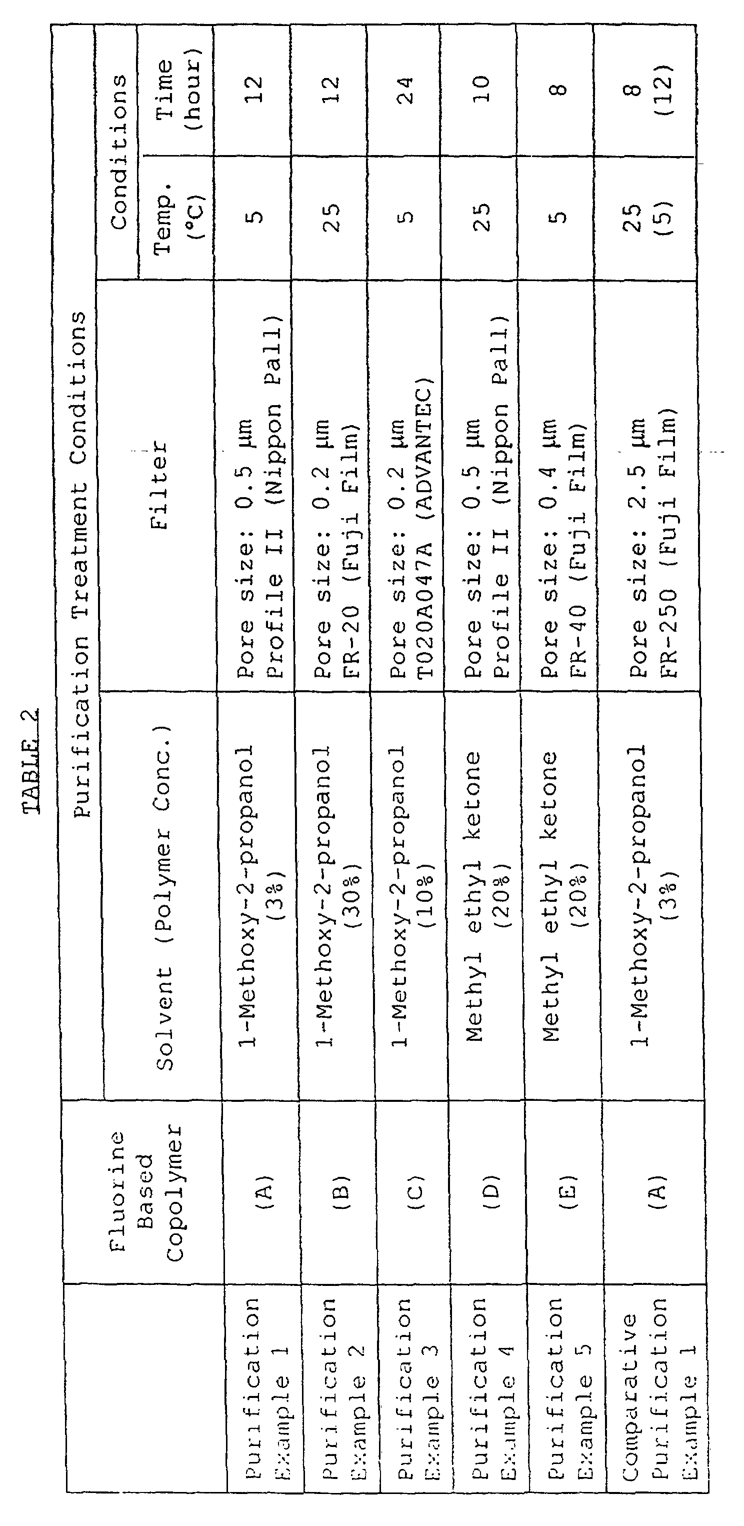

### PURIFICATION EXAMPLES 6 TO 10 AND COMPARATIVE PURIFICATION EXAMPLE 2

Adsorbents described in Table 3 were added to flasks in which the solutions of the crude fluorine based copolymers described in Table 1 in the solvents shown in Table 3 were placed. The resulting mixture was stirred with a magnetic stirrer under the conditions of temperature and time described in Table 3, followed by filtration, thereby purifying the fluorine based copolymers.

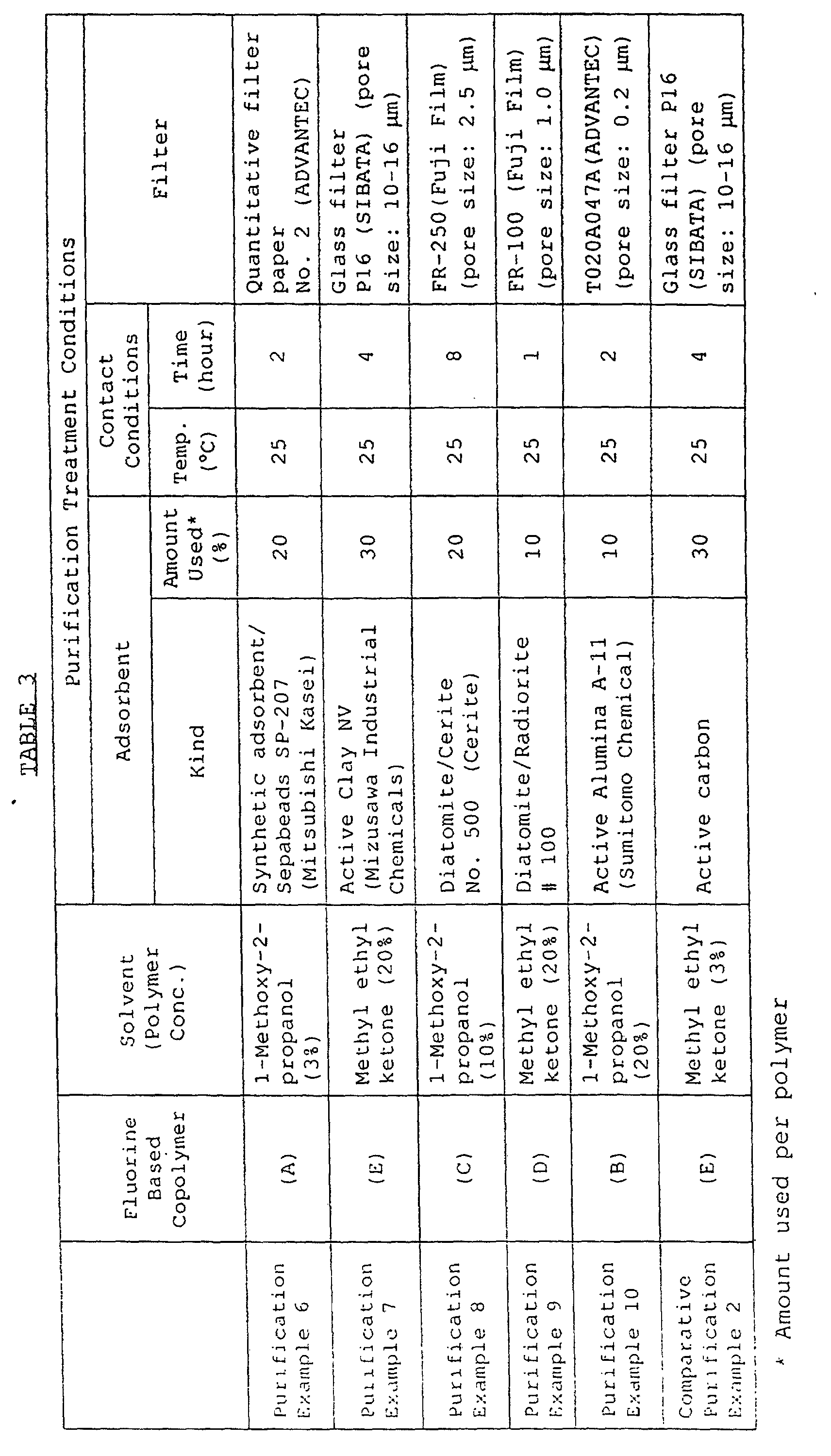

### COMPARATIVE PURIFICATION EXAMPLE 3

Fluorocarbon F-210 (manufactured by Dainippon Ink & Chemicals, Inc.) described in Table 4 was added to a flask in which the solution of the crude fluorine based copolymer (A) (Table 1) in a solvent shown in Table 4 were placed. The resulting mixture was stirred with a magnetic stirrer at 25°C for 3 hours, followed by still standing at 5°C for 24 hours. After layer separation, the fluorine based copolymer was taken out while filtering a supernatant through a filter paper to conduct purification (Table 4). The above-mentioned fluorocarbon was a fluorocarbon described in JP-A-1-149812.

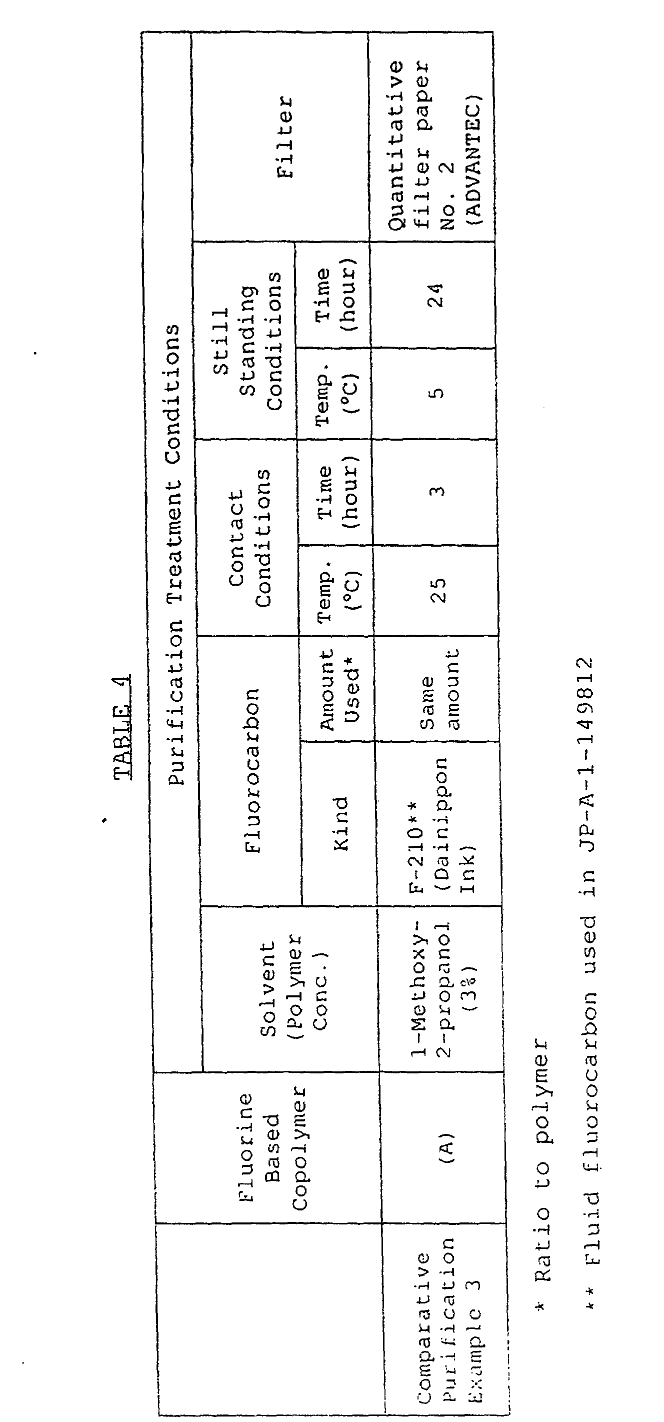

### EXAMPLES 1 TO 14 AND COMPARATIVE EXAMPLES 1 TO 15

A 0.24-mm thick aluminum plate (defined in JIS A 1050) was brush-grained with rotary nylon brushes shown below, while supplying an aqueous suspension of purmicestone having an average particle size of about 2.1 µm to a surface of the aluminum plate. A first brush had a bristle length of 100 mm, a bristle diameter of 0.95 mm and a bristle transplant density of 70 bristles/cm², and a second brush had a bristle length of 80 mm, a bristle diameter of 0.295 mm and a bristle transplant density of 670 bristles/cm². The brush rolls were both rotated at 250 rpm. The brush graining was followed by well washing with water. Then, the plate was immersed in 10% sodium hydroxide at 60°C for 25 seconds to conduct etching, and further washed with running water, followed by neutralization and washing with 20% nitric acid and washing with water. This was subjected to electrolytical graining using alternating waveform current of a sine wave under the conditions of VA = 12.7 V in a 1% aqueous solution of nitric acid at a quantity of anodal electricity of 160 coulombs/dm². The value of the surface roughness measured showed 0.79 µm (Ra indication). Subsequently, it was immersed in a 1% aqueous solution of sodium hydroxide at 40°C for 30 seconds, and then, immersed in a 30% aqueous solution of sulfuric acid. After desmutting treatment at 60°C for 40 seconds, anodic oxidation was carried out with direct current in a 20% aqueous solution of sulfuric acid at a current density of 2 A/dm² so as to give an oxide film weight of 1.6 g/m², thereby preparing a substrate.

An undercoat solution (A) having the following composition was coated onto a surface of the substrate, and dried at 80°C for 30 seconds. The amount of the coating film dried was 10 mg/m².
Undercoat (A)

| | |
|---|---|
| β-Alanine | 0.10 g |
| Methanol | 40 g |
| Pure Water | 60 g |

Thus, a substrate (I) was prepared.

Then, 20 ml of the following coating solution was dripped onto an edge of a 300 mm × 300 mm plate of the substrate (I) to conduct flow coating, and dried with hot air at 100°C for 1 minute to form a photosensitive layer corresponding to a photosensitive lithographic printing plate.

However, fluorine based copolymers were used as solutions.

| Coating Solution for Photosensitive Layer | |
|---|---|
| Esterified Product of 1,2-Diazonaphthoquinone-5-sulfonyl Chloride and Pyrogallol-Acetone Resin (described in Example 1 of U.S. Patent 3,635,709) | 1.60 parts |
| Cresol-Formaldehyde Novolak Resin (m:p ratio; 6:4, weight average molecular weight: 8000) | 4.20 parts |
| Phenol-Formaldehyde Novolak Resin (weight average molecular weight: 15000) | 0.50 part |
| Naphthoquinone-1,2-diazido-4-sulfonyl Chloride | 0.04 part |
| Tetrahydroxyphthalic Anhydride | 0.15 part |
| Dye in Which Counter Anion of Victoria Pure Blue BOH (Manufactured by Hodogaya Chemical Co., Ltd.) Was Changed to 1-Naphthalenesulfonic Acid | 0.07 part |

| Fluorine Based Copolymer | Amount described in Table 5 (converted to solid content) |
|---|---|
| Methyl Ethyl Ketone | 26 parts |
| 1-Methoxy-2-propanol | 18 parts |

The number of cissing spots of the resulting photosensitive layers are shown in Table 5. When the crude fluorine based copolymers were used, many cissing spots were observed (Comparative Exemples 1 to 9). When the fluorine based copolymer purified by use of the filter having a pore size of larger than 1.0 µm, or the adsorbent (active cabon) other than the synthetic adsorbent or inorganic adsorbents such as silicon oxide and aluminum oxide was used, cissing was also apparently observed (Comparative Exemples 10 to 14). Further, when the fluorine based copolymer was purified using the fluorocarbon disclosed in JP-A-1-149812, cissing was also observed (Comparative Example 15). In contrast, when the fluorine based copolymers were used which were purified using the filters having a pore size of 1.0 µm or less, the synthetic adsorbent or the inorganic adsorbents such as active clay, diatomite and active alumina, no cissing was observed (Examples 1 to 14).

**TABLE 5**

| | Fluorine Based Copolymer | Amount Added (part) | Number of Cissing Spots |
|---|---|---|---|
| Example 1 | (A) Polymer of Purification Example 1 | 0.1 | 0 |
| Example 2 | (A) polymer of Purification Example 1 | 1.0 | 0 |
| Example 3 | (B) Polymer of Purification Example 2 | 0.5 | 0 |
| Example 4 | (B) Polymer of Purification Example 2 | 1.0 | 0 |
| Example 5 | (C) Polymer of Purification Example 3 | 0.5 | 0 |
| Example 6 | (D) Polymer of Purification Example 4 | 1.0 | 0 |
| Example 7 | (E) Polymer of Purification Example 5 | 1.0 | 0 |
| Example 8 | (A) Polymer of Purification Example 6 | 0.5 | 0 |
| Example 9 | (E) Polymer of Purification Example 7 | 1.0 | 0 |
| Example 10 | (C) Polymer of Purification Example 8 | 0.2 | 0 |
| Example 11 | (C) Polymer of Purification Example 8 | 1.0 | 0 |
| Example 12 | (D) Polymer of Purification Example 9 | 0.5 | 0 |
| Example 13 | (D) Polymer of Purification Example 9 | 1.0 | 0 |
| Example 14 | (B) Polymer of Purification Example 10 | 1.0 | 0 |
| Comparative Example 1 | (A) Crude | 0.01 | 120 |
| Comparative Example 2 | (A) Crude | 0.1 | 560 |
| Comparative Example 3 | (A) Crude | 1.0 | >1000 |
| Comparative Example 4 | (B) Crude | 0.1 | 38 |
| Comparative Example 5 | (B) Crude | 0.5 | 160 |
| Comparative Example 6 | (B) Crude | 1.0 | 250 |
| Comparative Example 7 | (C) Crude | 1.0 | 180 |
| Comparative Example 8 | (D) Crude | 0.1 | 83 |
| Comparative Example 9 | (E) Crude | 1.0 | 360 |
| Comparative Example 10 | (A) Polymer of Comparative Purification Example 1 | 0.01 | 8 |
| Comparative Example 11 | (A) Polymer of Comparative Purification Example 1 | 0.1 | 28 |
| Comparative Example 12 | (A) Polymer of Comparative Purification Example 1 | 1.0 | 37 |
| Comparative Example 13 | (E) Polymer of Comparative Purification Example 2 | 0.5 | 24 |
| Comparative Example 14 | (E) Polymer of Comparative Purification Example 2 | 1.0 | 63 |
| Comparative Example 15 | (A) Polymer of Comparative Purification Example 3 | 1.0 | 12 |

### EXAMPLES 15 TO 20 AND COMPARATIVE EXAMPLES 16 TO 20

A 0.24-mm thick aluminum plate (defined in JIS A1050) was brush grained with rotary nylon brushes shown below, while supplying an aqueous suspension of purmicestone having an average particle size of about 2.1 µm to a surface of the aluminum plate. A first brush had a bristle length of 100 mm, a bristle diameter of 0.95 mm and a bristle transplant density of 70 bristles/cm², and a second brush had a bristle length of 80 mm, a bristle diameter of 0.295 mm and a bristle transplant density of 670 bristles/cm². The brush rolls were both rotated at 250 rpm. The brush graining was followed by well washing with water. Then, the plate was immersed in 10% sodium hydroxide at 60°C for 25 seconds to conduct etching, and further washed with running water, followed by neutralization and washing with 20% nitric acid and washing with water. This was subjected to electrolytical graining using alternating waveform current of a sine wave under the conditions of VA = 12.7 V in a 1% aqueous solution of nitric acid at a quantity of anodal electricity of 160 coulombs/dm². The value of the surface roughness measured showed 0.79 µm (Ra indication). Subsequently, it was immersed in a 1% aqueous solution of sodium hydroxide at 40°C for 30 seconds, and then, immersed in a 30% aqueous solution of nitric acid. After desmutting treatment at 60°C for 40 seconds, anodic oxidation was carried out with direct current in a 20% aqueous solution of sulfuric acid at a current density of 2 A/dm² so as to give an oxide film weight of 1.6 g/m², thereby preparing a substrate.

An undercoat solution (A) having the following composition was coated onto a surface of the substrate, and dried at 80°C for 30 seconds. The amount of the coating film dried was 10 mg/m².
Undercoat (A)

| | |
|---|---|
| β-Alanine | 0.10 g |
| Methanol | 40 g |
| Pure Water | 60 g |

Thus, a substrate (I) was prepared.

A photosensitive solution shown below was applied onto this substrate (I) in an amount of 12 ml/m² by rod coating, and dried at 100°C for 1 minute to obtain a positive working photosensitive lithographic printing plate. The amount coated after drying was 1.15 g/m². For shortening the vacuum contact time, a matte layer was plated as described in JP-B-61-28986.

| Coating Solution for Photosensitive Layer | |
|---|---|
| Esterified Product of 1,2-Diazonaphthoquinone-5-sulfonyl Chloride and Pyrogallol-Acetone Resin (described in Example 1 of U.S. Patent 3,635,709) | 0.80 part |
| Cresol-Formaldehyde Novolak Resin (m:p ratio; 6:4, weight average molecular weight: 8000) | 1.5 parts |
| Phenol-Formaldehyde Novolak Resin (weight average molecular weight: 15000) | 0.2 part |
| Naphthoquinone-1,2-diazido-4-sulfonyl Chloride | 0.02 part |
| Tetrahydroxyphthalic Anhydride | 0.16 part |
| 4-[p-N,N-Bis(ethoxycarbonylmethyl)aminophenyl]-2,6-bis(trichloromethyl)-striazine | 0.07 part |
| Dye in Which Counter Anion of Victoria Pure Blue BOH (Manufactured by Hodogaya Chemical Co., Ltd.) Was Changed to 1-Naphthalenesulfonic Acid | 0.0045 part |
| F-176PF (Fluorine Based Surfactant Manufactured by Dainippon Ink & Chemicals, Inc.) | 0.01 part |
| Fluorine Based Copolymer | 0.1 part |
| Methyl Ethyl Ketone | 15 parts |
| 1-Methoxy-2-propanol | 10 parts |

A positive transparent original film of a line original and a halftone dot image was brought into close contact with the photosensitive layer of the photosensitive lithographic printing plate, followed by exposure to a carbon arc lamp of 30 amperes from a distance of 70 cm.

The photosensitive lithographic printing plate exposed was immersed in an eightfold aqueous dilution of DP-4 (trade name, manufactured by Fuji Photo Film Co., Lta.) at 25°C for 60 seconds to develop it.

Using the resulting lithographic printing plate, a print was made on woodfree paper with commercial ink by use of a KOR printing machine (manufactured by Heidelberg Co.). Results of examination of the state of blank spots in printed image areas are as shown in Table 6.

**TABLE 6**

| | Fluorine Based Copolymer | Evaluation of Printed Image* |
|---|---|---|
| Example 15 | (A) Polymer of Purification Example 1 | A |
| Example 16 | (B) Polymer of Purification Example 2 | A |
| Example 17 | (E) Polymer of Purification Example 5 | A |
| Example 18 | (C) Polymer of Purification Example 8 | A |
| Example 19 | (D) Polymer of Purification Example 9 | A |
| Example 20 | (B) Polymer of Purification Example 10 | A |
| Comparative Example 16 | (A) Crude | D |
| Comparative Example 17 | (E) Crude | C |
| Comparative Example 18 | (A) Polymer of Compa-ative Purification Example 1 | C |
| Comparative Example 19 | (E) Polymer of Comparative Purification Example 2 | B |
| Comparative Example 20 | (A) Polymer of Comparative Purification Example 3 | B |

| | | |
|---|---|---|
| * The standard of printed image evaluation | | |

A: An image was good;
B: Blank spots were slightly observed;
C: Blank spots were observed; and
D: Blank spots were significantly observed.

As is apparent from Table 6, when prints were made using the photosensitive lithographic printing plates of the present invention, no blank spots was observed at all (Examples 15 to 20). In contrast, when the photosensitive lithographic printing plate using the crude fluorine based copolymer (A) was employed, significant blank spots were observed after printing. Further, when the photosensitive lithographic printing plates using the crude fluorine based copolymer (E) and the fluorine based copolymer of Comparative Purification Example 1 (the fluorine based copolymer purified by use of the filter having a pore size of 2.5 µm), respectively) were employed, blank spots were also observed (Comparative Examples 17 and 18). When the fluorine based copolymers of Comparative Purification Examples 2 and 3 (the fluorine based copolymers purified with active carbon and fluorocarbon. respectively) were used, blank spots were also slightly observed.

As described above, the use of the photosensitive lithographic printing plates of the present invention gives the homogeneous layers having no cissing in forming the photosensitive layers on the supports by coating. After printing of the photosensitive lithographic printing plates provided with such homogeneous photosensitive layers, no blank spots is observed to give good printed images.

## Claims

1. A photosensitive lithographic printing plate prepared by coating a support with a solution containing a fluorine based copolymer, a photosensitive compound, a binder and an organic solvent, followed by drying, said fluorine based copolymer being obtained by dissolving a copolymer having 1% to 80% by weight of a fluoro-substituted (meth)acrylate as a constituent unit in a solvent, and then, purifying the fluoro-substituted (meth)acrylate-containing copolymer by bringing the resulting solution into contact with an inorganic adsorbent containing 80wt.-% or more of an oxide of silicon, an oxide of aluminum or a mixture thereof.

2. A photosensitive lithographic printing plate prepared by coating a support with a solution containing a fluorine based copolymer, a photosensitive compound, a binder and an organic solvent, followed by drying, said fluorine based copolymer being obtained by dissolving a copolymer having 1% to 80% by weight of a fluoro-substituted (meth)acrylate as a constituent unit in a solvent, and then, purifying the fluoro-substituted (meth)acrylate-containing copolymer by bringing the resulting solution into contact with a synthetic adsorbent comprising a (modified) styrene-divinylbenzene copolymer or a (meth)acrylic ester based copolymer.

3. A photosensitive lithographic printing plate prepared by coating a support with a solution containing a fluorine based copolymer, a photosensitive compound, a binder and an organic solvent, followed by drying, said fluorine based copolymer being obtained by dissolving a copolymer having 1% to 80% by weight of a fluoro-substituted (meth)acrylate as a constituent unit in a solvent, and then, purifying the fluoro-substituted (meth)acrylate-containing copolymer by filtering the resulting solution through a filter having a pore size of 1 µm or less.

4. The photosensitive lithographic printing plate as in claim 1, wherein said fluorine based copolymer is purified by further filtering the solution of the fluorine based copolymer dissolved in the solvent through a filter having a pore size of 1 µm or less.

5. The photosensitive lithographic printing plate as in claim 2, wherein said fluorine based copolymer is purified by further filtering the solution the fluorine based copolymer dissolved in the solvent through a filter having a pore size of 1 µm or less.

## Patentansprüche

1. Photoempfindliche lithographische Druckplatte, hergestellt durch Beschichtung eines Trägers mit einer Lösung, die ein auf Fluor basierendes Copolymer, eine photoempfindliche Verbindung, ein Bindemittel und ein organisches Lösungsmittel enthält, gefolgt von einem Trockenschritt, wobei das auf Fluor basierende Copolymer durch Lösen eine Copolymers mit 1 bis 80 Gew.-% eines Fluor-substituierten (Meth)acrylats als konstitutiver Einheit in einem Lösungsmittel erhalten wird und daraufhin Reinigung des Fluor-substituierten (Meth)acrylat-haltigen Copolymers, indem die resultierende Lösung mit einem anorganischen Adsorbens in Kontakt gebracht wird, das 80 Gew.-% oder mehr eines Siliciumoxids, eines Aluminiumoxids oder einer Mischung davon enthält.

2. Photoempfindliche lithographische Druckplatte, hergestellt durch Beschichtung eines Trägers mit einer Lösung, die ein auf Fluor basierendes Copolymer, eine photoempfindliche Verbindung, ein Bindemittel und ein organisches Lösungsmittel enthält, gefolgt von einem Trockenschritt, wobei das auf Fluor basierende Copolymer durch Lösen eines Copolymers. in einem Lösungsmittel erhalten wird, wobei es 1 bis 80 Gew.-% eines Fluor-substituierten (Meth)acrylats als konstitutive Einheit enthält, und dann Reinigung des Fluor-substituierten (Meth)acrylat-haltigen Copolymers, indem die resultierende Lösung mit einem synthetischen Adsorbens in Kontakt gebracht wird, umfassend ein (modifiziertes) Styrol-Divinylbenzol-Copolymer oder ein auf (Meth)acrylsäureester basierendes Copolymer.

3. Photoempfindliche lithographische Druckplatte, hergestellt durch Beschichtung eines Trägers mit einer Lösung, enthaltend ein auf Fluor basierendes Copolymer, eine photoempfindliche Verbindung, ein Bindemittel und ein organisches Lösungsmittel, gefolgt von einem Trockenschritt, wobei das auf Fluor basierende Copolymer erhalten wird, indem ein Copolymer mit 1 bis 80 Gew.-% eines Fluor-substituierten (Meth)acrylats als konstitutiver Einheit in einem Lösungsmittel gelöst wird und daraufhin Reinigung des Fluor-substituierten (Meth)acrylat-haltigen Copolymers durch Filtern der resultierenden Lösung durch einen Filter mit einer Porengröße von 1 µm oder weniger.

4. Photoempfindliche lithographische Druckplatte gemäß Anspruch 1, wobei das auf Fluor basierende Copolymer durch weiteres Filtern der Lösung des auf Fluor basierenden Copolymers, gelöst in dem Lösungsmittel, durch einen Filter mit einer Porengröße von 1 µm oder weniger gereinigt wird.

5. Photoempfindliche lithographische Druckplatte gemäß Anspruch 2, wobei das auf Fluor basierende Copolymer durch weiteres Filtern der Lösung des auf Fluorbasierenden Copolymers, gelöst in einem Lösungsmittel, durch einen Filter mit einer Porengröße von 1 µm oder weniger gereinigt wird.

## Revendications

1. Une planche d'impression lithographique photosensible préparée par revêtement d'un support au moyen d'une solution contenant un copolymère à base de fluor, un composé photosensible, un liant et un solvant organique, suivi par un séchage, ledit copolymère à base de fluor étant obtenu par dissolution d'un copolymère ayant de 1% à 80% en poids d'un fluoro(méth)acrylate substitué en tant qu'entité constitutive dans un solvant, suivi de la purification du copolymère contenant du fluoro(méth)acrylate substitué en mettant en contact la solution résultante avec un adsorbant inorganique contenant 80% en poids ou davantage d'un oxyde de silicium, d'un oxyde d'aluminium ou de leur mélange.

2. Une planche d'impression lithographique photosensible préparée par revêtement d'un support au moyen d'une solution contenant un copolymère à base de fluor, un composé photosensible, un liant et un solvant organique, suivi par un séchage, ledit copolymère à base de fluor étant obtenu par dissolution d'un copolymère ayant de 1% à 80% en poids d'un fluoro(méth)acrylate substitué en tant qu'entité constitutive dans un solvant, suivi de la purification du copolymère contenant du fluoro(méth)acrylate substitué en mettant en contact la solution résultante avec un adsorbant synthétique comprenant un copolymère (modifié) styrène-divinylbenzene ou un copolymère à base d'ester (méth)acrylique.

3. Une planche d'impression lithographique photosensible préparée par revêtement d'un support au moyen d'une solution contenant un copolymère à base de fluor, un composé photosensible, un liant et un solvant organique, suivi par un séchage, ledit copolymère à base de fluor étant obtenu par dissolution d'un copolymère ayant de 1% à 80% en poids d'un fluoro(méth)acrylate substitué en tant qu'entité constitutive dans un solvant, suivi de la purification du copolymère contenant du fluoro(méth)acrylate substitué en filtrant la solution résultante à travers un filtre ayant une taille de pore de 1 µm ou moins.

4. La planche d'impression lithographique photosensible telle que dans la revendication 1, dans laquelle ledit copolymère à base de fluor est purifié en filtrant en outre la solution du copolymère à base de fluor dissous dans le solvant à travers un filtre ayant une taille de pore de 1 µm ou moins.

5. La planche d'impression lithographique photosensible telle que dans la revendication 2, dans laquelle ledit copolymère à base de fluor est purifié en filtrant en outre la solution du copolymère à base de fluor dissous dans le solvant à travers un filtre ayant une taille de pore de 1 µm ou moins.
